Europäisches Patentamt

**European Patent Office**

Office européen des brevets

(19)

(11) Numéro de publication: **0 000 318**

**B1**

(12)

# FASCICULE DE BREVET EUROPEEN

(21) Numéro de dépôt: **78430004.8**

(22) Date de dépôt: **22.06.78**

(51) Int. Cl.³: **H 01 L 29/82, H 01 L 29/10, G 01 R 33/06, G 01 R 29/08**

(54) Détecteur de champ magnétique ou électrique, à structure semi-conductrice à effet de champ

(30) Priorité: **01.07.77 US 812298**

(43) Date de publication de la demande:
**10.01.79 Bulletin 79/01**

(45) Mention de la délivrance du brevet:
**07.01.81 Bulletin 81/01**

(84) Etats contractants désignés:
**BE CH DE FR GB NL SE**

(56) Documents cités:
DE - A - 023 261
FR - A - 2 239 017

**APPLIED PHYSICS LETTERS,
vol 25, nr. 10, 15 novembre 1974,
New York, USA
D. J. BARTELINK et G. PERSKY
"Magnetic sensitivity of a distributed Si planar
PNPN structure supporting a controlled current
filament", pages 590—592
INSTITUTE OF ELECTRICAL AND ELECTRONICS
ENGINEERS,
International Electron devices meeting technical
digest Washington, December 6—8 1976,
IEEE, 1976, USA
New York
W. P. NOBLE & P. E. COTTRELL "Narrow channel
effects in insulated gate field effect transistors",
pages 582—586**

(73) Titulaire: **International Business Machines
Corporation
Armonk, N.Y. 10504 (US)**

(72) Inventeur: **Vinal, Albert, Watson
810 Queensferry Road
Cary, NC 27511 (US)**

(74) Mandataire: **Siccardi, Louis
COMPAGNIE IBM FRANCE
Département de Propriété Industrielle
F - 06610 La Gaude (FR)**

# 0 000 318

Détecteur de champ magnétique ou électrique, à structure semi-conductrice à effet de champ

## Domaine technique de l'invention

La présente invention concerne les détecteurs de champs magnétiques ou électriques et, plus particulièrement, les détecteurs semi-conducteurs du type à transistor à effet de champ.

## Etat de la technique antérieure

Les détecteurs magnétiques à transistor à effet de champ (FET) de l'art antérieur font appel à l'emploi de l'effect Lorentz en vertu duquel les porteurs qui circulent entre la source et un ou plusieurs drains d'un transistor FET font l'objet d'une déviation. Cet effet permet de créer un déséquilibre dans les courants de drain du transistor de manière à obtenir une sortie différentielle. A cet égard, on se reportera, par exemple, à la publication intitulée "IBM Technical Disclosure Bulletin", Vol. 13, No. 12, mai 1971, page 3633, ou au brevet britannique GB-A-1 243 178 qui décrit un détecteur magnétique comportant un transistor FET dont le canal est pourvu à ses extrémités opposées d'une source et de deux ou trois drains. Ainsi que le comprendra l'homme de l'art, une couche convenable faisant fonction de porte et une couche d'oxyde servant d'isolant sont également formées dans de tels dispositifs afin de commander la circulation du courant dans le canal. Dans le brevet britannique précité, l'application d'une tension appropriée à la porte permet d'établir une couche d'inversion servant de canal conducteur. Ce dernier s'étend entre la source et deux ou trois drains. La source est reliée à la masse et les drains à une tension d'alimentation par l'intermédiaire de charges résistives qui peuvent être de même valeur. On sait que, lorsque des tensions convenables sont appliquées à la source, au(x) drain(s) et à la porte, un courant circule entre la source et le ou les drain(s). On a pensé que ce courant pouvait faire l'objet d'une déviation par suite de l'effet Lorentz résultant de la présence d'un champ magnétique dans la trajectoire des porteurs de charge et que cela provoquait une accumulation des charges sur un côté du canal et un appauvrissement des charges sur le côté opposé jusqu'à ce que le champ électrique créé par le déplacement des charges ait appliqué aux porteurs de charge une force égale à celle résultant du champ magnétique et opposée à celle-ci.

Ce phénomène classique en vertu duquel une accumulation des charges se produirait dans le canal pour contre-balancer la déviation des porteurs de charge, s'est traduit par l'emploi de canaux relativement larges dans les dispositifs à transistors FET afin que les porteurs de charge puissent faire l'objet d'une déviation sans qu'il en résulte pour autant une inter-action (ou une "accumulation des charges") importante. Il est évident qu'un canal large permet la circulation de courants relativement plus importants qu'un canal étroit. Dans le mode différentiel, un petit nombre seulement de porteurs de charge (ceux qui se trouvent à proximité du centre du canal) sont effectivement déviés de manière à frapper un drain particulier plutôt qu'un autre. La majorité des porteurs qui se trouvent dans un canal large s'ajoutent par conséquent au courant obtenu aux drains sans subir l'effet Lorentz. De ce fait, les tensions de bruit produites dans les résistances de charge sont plus importantes que dans le cas d'un dispositif à canal étroit. D'autre part, étant donné qu'un petit nombre seulement de porteurs peut être dévié de manière à produire un signal, les niveaux des signaux obtenus risquent d'être relativement plus faibles qu'on pourrait le désirer par rapport aux niveaux de bruit. Par ailleurs, du fait de la largeur relativement plus grande que présente un canal de ce type, la résolution du dispositif, c'est-à-dire la bande la plus étroite du flux magnétique qui peut être utilisée pour dévier les porteurs qui produisent un signal de sortie, sera moins grande.

Le fait que l'on utilise des canaux larges, c'est-à-dire des canaux dont la largeur est supérieure à celle de la plus petite source ou du plus petit drain, indique que l'on n'a pas tenu compte dans l'art antérieur de la largeur des régions d'appauvrissement qui se trouvent le long des limites du canal. En effet, ces régions constituent une partie insignifiante de la largeur du canal dans de tels dispositifs.

Des agencements classiques d'un type légèrement différent utilisent des dispositifs bipolaires ou à jonction dans lesquels la source et le ou les drains se composent de matériaux de conductivités différentes qui sont enterrés dans un substrat semi-conducteur. De tels dispositifs sont décrits par exemple dans les brevets des E.U.A. US-A-3 167 663, 3 714 559, 3 731 123 et 3 829 883. L'un des problèmes qui se posent en pareil cas réside dans la difficulté que présente l'obtention d'une sensibilité élevée et de signaux de sortie d'amplitude suffisamment grande avec des rapports signal/bruit acceptables en travaillant dans des largeurs de bande suffisantes. Dans les brevets précités US-A-3 714 559 et 3 829 883 on a décrit un détecteur de champ magnétique à transistor FET à drains multiples dont le fonctionnement est tel que la porte soit polarisée à une valeur inférieure au seuil du transistor et que le premier drain soit polarisé de manière à produire une rupture par avalanche (ce qui constitue une source importante de bruit dans les transistors FET) de la jonction avec le substrat, le second et le troisième drains étant polarisés à une tension inférieure à celle qui est nécessaire pour obtenir une rupture par avalanche de leurs jonctions. Dans ce mode de fonctionnement, le canal du transistor FET n'est pas effectivement rendu conducteur, si bien qu'il n'y a pas lieu d'employer de transistors FET dans ce type de dispositif puisqu'aucun "canal" n'existe. Dans ces mêmes brevets et selon un autre mode de réalisation, l'un au moins des drains est du même type de conductivité que le substrat, mais est plus fortement dopé. Ce dernier dispositif permet d'obtenir un courant entre la diffusion de source et la jonction et fonctionne en apparence davantage comme une diode. Ces dispositifs présentent une sensibilité élevée, des signaux de sortie d'amplitude relativement grande et des rapports signal/bruit excellents, mais ne sont pas utilisés en tant que transistors FET. Leur action s'exerce, croît-on, en accélérant les trous qui ont été déviés par un champ magnétique, et ces porteurs minoritaires présenteraient une plus grande sensibilité. Les difficultés que présentent le contrôle des ruptures par avalanche et la génération de paires trou-électron en nombre suffisant pour permettre la circulation d'un courant de trous entre la source et le drain, peuvent se révéler insurmontables dans certaines applications.

Les brevets des E.U.A. précités US-A-3 167 663 et 3 731 123 décrivent d'autres détecteurs de champ magnétique du type à jonction P—N (bipolaire) fonctionnant essentiellement comme des diodes, dans lesquelles la circulation du courant peut être modifiée ou dirigée au moyen de champs magnétiques externes. Ces dispositifs fonctionneraient dans la région de circulation d'un courant important dans laquelle les porteurs injectés sont déviés par l'effet Lorentz de telle sorte que l'on obtienne un déplacement latéral des porteurs et un signal de sortie différentiel entre deux drains ou davantage à jonction P—N. Ces dispositifs possèdent des courants intrinséques plus élevés et, bien qu'ils puissent être sensibles aux champs magnétiques, présentent un sensibilité plus grande aux courants de bruit.

Le brevet des E.U.A. US-A-3 593 045 décrit un dispositif de type analogue dans lequel un faisceau d'électrons injectés créé à une jonction P—N dans un dispositif semi-conducteur serait dévié vers une ou plusieurs cibles par des champs électriques ou magnétiques. Ce dispositif n'est pas employé en tant que transistor FET et exige, comme il est dit dan ce brevet, des courants de commande et de polarisation relativement élevés, de l'ordre de 200 volts, ce qui empêche son utilisation dans des circuits intégrés à effet de champ.

Il existe par ailleurs des dispositifs à effet Hall qui n'utilisent pas directement la déviation des porteurs, mais qui tirent parti de la tension résiduelle due à la déflexion, créée par l'effet Lorentz, de lignes équipotentielles des porteurs transversalement aux connexions d'entrée et de sortie. De tels dispositifs sont décrits en particulier dans le brevet des E.U.A. US-A-3 448 353. Ils présentent en général de faibles rapports longueur/largeur (inférieurs à trois à un environ) et fonctionnent dans des conditions optimum lorsque leur longueur est égale à leur largeur. Il est également bien connu que, dans ces dispositifs à effet Hall, le signal de sortie est proportionnel à la vitesse des porteurs et non au nombre de ceux-ci. Etant donné qu'il ne s'agit pas en l'occurrence de dispositifs à transistors FET dont le fonctionnement est tel qu'un faisceau de porteurs soit dévié et qu'un signal de sortie différentiel soit obtenu aux drains, seule une tension de sortie peut être employée d'un côté ou de l'autre du canal. Il est préférable qu'un courant de signal effectif soit obtenu à l'un ou l'autre des drains comme dans le cas du dispositif décrit dans le brevet britannique précité.

Il existe également dans l'art antérieur des dispositifs à charge couplée qui permettent de commander l'état du courant circulant dans le canal relativement large d'un transistor FET (voir notamment la publication intitulée "IBM Technical Disclosure Bulletin", Vol. 14, No. 11, avril 1972, page 3420 et le brevet des E.U.A. US-A-3 714 523). Le dispositif décrit dans ce dernier brevet constitue un détecteur extrêmement sensible de champs magnétiques, et utilise à cette fin un contrôle différentiel des électrodes de porte couplées depuis les drains de manière à obtenir une réaction positive. Les dispositifs à charge couplée de ce type permettent également d'obtenir des signaux de sortie amplifiés.

Toutefois, compte tenu de la largeur relativement plus importante de ces dispositifs et des courants plus importants qui les traversent, une tension de bruit plus élevée risque d'être obtenue en sortie et serait alors amplifiée par le mécanisme de réaction. La grande largeur de ces dispositifs indique évidemment que les régions d'appauvrissement qui se trouvent de part et d'autre du canal constituent une partie insignifiante de la largeur totale de ce dernier.

Exposé de l'invention

La présente invention a pour but de remédier aux difficultés rencontrées avec les dispositifs de détection de champs magnétiques ou électriques de l'art antérieur, en fournissant un détecteur du type comportant un substrat de matériau semi-conducteur dans lequel sont formés une région de source et au moins deux régions de drains distinctes ainsi qu'un canal de conduction reliant la région de source auxdites régions de drains, ce détecteur étant caractérisé en ce que son canal de conduction est en forme de filament, le rapport entre la largeur totale du canal diminuée de la somme des largeurs des régions d'appauvrissement se trouvant le long des côtés du canal, d'une part, et la largeur totale du canal, d'autre part, ayant une valeur supérieure à 0 et inférieure à 0,98 au voisinage de ladite région de source.

Le canal en forme de filament est caractérisé par un rapport longueur/largeur relativement élevé. Dans ce canal, un faisceau étroit de porteurs de charge peut faire l'objet d'une déviation maximale vers la droite ou vers la gauche au moyen d'un mécanisme de modulation de la largeur des régions d'appauvrissement qui constituent une partie relativement importante de la largeur totale du canal.

La largeur totale du canal diminuée de deux fois la largeur de la zone d'appauvrissement sera appelée ici "largeur Vinhall".

3

Le détecteur selon l'invention sera appelé ici "détecteur Vinhall". Dans un tel détecteur la largeur minimum du canal est égale à deux fois au moins la largeur de la région d'appauvrissement. Cette largeur minimum correspond à une largeur Vinhall nulle.

La longueur d'un tel dispositif doit être suffisamment grande pour permettre d'éviter un court-circuit ou un claquage dans le canal entre la source et les drains.

La plage résultante de rapports longueur/largeur qui peut être définie, correspond à la création de canaux de conduction qui sont plus étroits d'un à deux ordres de grandeur ($10^{-1}$ à $10^{-2}$) que ceux de l'art antérieur. Les détecteurs selon l'invention, présentent une sensibilité et des rapports signal/bruit beaucoup plus grands que ceux obtenus avec les dispositifs de l'art antérieur.

## Description des figures des dessins

La figure 1 représente une vue de dessus d'un dispositif à canal conducteur du type filament créé dans un substrat en matériau semi-conducteur ou même au-dessous de la surface de celui-ci.

La figure 2 représente une coupe longitudinale, prise selon la ligne A—A de la figure 1, pour le type de canal qui peut être créé par enrichissement, c'est-à-dire en appliquant une tension appropriée à une porte de commande, de manière à induire la présence de porteurs de charge dans une région du canal et d'obtenir une conduction à la surface du substrat.

Les figures 3A à 3D sont des vues de dessus de deux dispositifs à conduction de canal du type filament à source unique et à drains multiples, et montrent les effets du pincement sur les régions d'appauvrissement et sur les largeurs Vinhall.

La figure 4 est une vue en coupe d'un dispositif à canal de conduction profondément implanté ou enterré du type filament de la présente invention.

La figure 5 représente une variante du dispositif de la figure 4.

La figure 6 est une schéma permettant de calculer le courant de canal nécessaire pour obtenir une conduction dans l'un ou l'autre des modes de fonctionnement et de réalisation de la présente invention.

Les figures 7A à 7C montrent les effets d'une modulation de la largeur de la région d'appauvrissement sur des détecteurs conformes à la présente invention.

La figure 8 est une vue de dessus d'une petite partie d'un canal conducteur et montre un espacement hypothétique des porteurs de charge imposé par les limites du canal.

La figure 9 est un graphique représentant le courant de canal en fonction de la tension pour un dispositif à transistors FET et montre les régions de fonctionnement et leurs points critiques.

Les figures 10A à 10C représentent respectivement la région de charge d'espace, le champ électrique et le potentiel qui existent dans la jonction PN le long de chaque côté du canal conducteur dans des dispositifs conformes à la présente invention.

Les figures 11A à 11C représentent le mécanisme de modulation de la largeur de la région d'appauvrissement et la façon dont cette modulation provoque un déplacement effectif des limites du canal conducteur dans des dispositifs conformes à la présente invention.

La figure 12 représente un détecteur typique réalisé conformément à l'invention et montre les régions d'appauvrissement qu'il comporte.

Les figures 13A et 13B représentent un dispositif typique à effet Hall et la position des régions d'appauvrissement qu'il comporte dans des conditions optimales. Ces figures représentent également le gradient de vitesse des porteurs ou l'absence de celui-ci et son effet sur le fonctionnement des dispositifs.

Les figures 14A et 14B représentent des dispositifs typiques réalisés conformément à l'invention et montrent respectivement la modulation de la largeur de la région d'appauvrissement qui se produit avec et sans gradient de vitesse des porteurs.

La figure 15A et les figures 15B à 15E représentent respectivement une vue de dessus et des coupes d'un détecteur Vinhall typique réalisé conformément à la présente invention.

## Description de modes de réalisation de l'invention

Le principe de fonctionnement des dispositifs de la présente invention et les caractéristiques qui les distinguent des dispositifs de l'art antérieur sont décrits ci-après. Il est cependant nécessaire de formuler quelques remarques préliminaires. Tout d'abord, le dispositif selon l'invention posséde un canal conducteur qui, contrairement aux canaux des dispositifs de l'art antérieur, est rendu aussi étroit que possible.

Deuxièmement, le dispositif selon l'invention est un type distinct de détecteur de champs à déviation de l'écoulement des porteurs de charge. Son fonctionnement est complètement différent de celui des dispositifs à effet Hall. En effet, le dispositif Vinhall selon l'invention provoque une déviation des limites effectives des régions d'appauvrissement qui canalisent l'écoulement des porteurs de charge, et détecte les effets de cette déviation au niveau de deux drains de sortie ou davantage.

Une autre caractéristique du dispositif Vinhall réside dans le fait que l'on fait varier les limites de l'écoulement des porteurs de charge en modulant la largeur des régions d'appauvrissement du canal pour des écoulements de porteurs animés d'une vitesse contante ou présentant un gradient de vitesse. En revanche, un dispositif Hall ne produit aucun courant de sortie et, en fait, aucun courant ne pourrait être obtenu aux bornes de sortie d'un tel dispositif sans nuire gravement à son fonctionnement.

Ainsi qu'on le verra plus loin, l'obtention d'un signal à la sortie d'un dispositif à effet Hall nécessite l'existence d'un gradient des vitesses des porteurs dans son canal conducteur. C'est ce gradient et non le nombre de porteurs que le dispositif Hall utilise. Pour pouvoir fonctionner, un dispositif Hall a besoin dudit gradient afin d'agir sur les lignes équipotentielles qui se trouvent dans le canal et ainsi induire une différence de potentiel à la sortie du dispositif. Si l'on cherche à tirer un courant important de la ou des bornes de sortie, on risque de déformer la configuration des lignes équipotentielles et, par conséquent, d'empêcher le dispositif de fonctionner correctement. En revanche, le dispositif Vinhall de la présente invention fonctionne très efficacement sans aucun gradient de vitesse et fait appel au nombre et à la vitesse des porteurs qui se déplacent dans le canal. Qui plus est, la vitesse des porteurs et la largeur Vinhall ne présentent d'importance dans ce dernier dispositif que dans la région du canal qui se trouve à proximité des drains.

Troisièmement, on verra que, ce qui est plus important, le fonctionnement d'un dispositif Vinhall est fonction de l'épaisseur du canal, de la largeur Vinhall, ainsi que de la densité par unité de volume des porteurs de charge qui existent dans le substrat et dans le canal, ce qui est en opposition avec les enseignements de l'art antérieur selon lesquels il convient d'augmenter et non de diminuer la largeur du canal afin d'éviter l'accumulation des charges. On verra dans ce qui est décrit ci-après que des canaux étroits permettent d'obtenir un meilleur fonctionnement que des canaux larges.

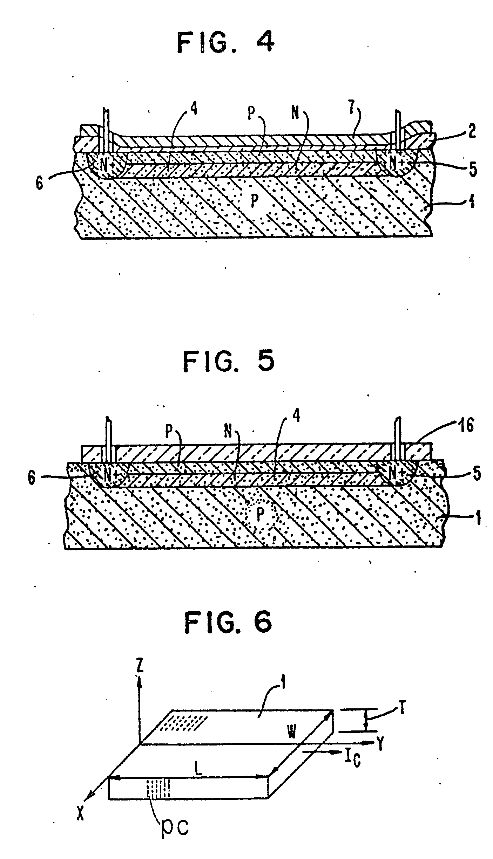

On se reportera à présent á la figure 6 qui représente un bloc de matériau semi-conducteur 1 qui peut être en silicium, en germanium, en arseniure de gallium ou en tout autre matériau ou composé présentant des propriétés semi-conductrices intrinsèques bien connues. Le bloc 1 comporte un certain nombre de porteurs de charge pc équidistants et répartis le long des axes x, y et z. Comme le montre la figure 6, la largeur W, l'épaisseur T et la longueur L sont respectivement mesurées le long des axes x, z et y. Aucune signification particulière ne s'attache au choix de la notation employée aux fins de l'exposé ci-dessous.

Pour analyser un dispositif Vinhall, il est nécessaire d'établir les formules donnant le courant de canal, la sortie du détecteur ainsi que des rapports signal/bruit pour un tel dispositif, de manière à permettre une comparaison avec les dispositifs Hall.

On rappellera tout d'abord certains principes de physique nécessaires à la compréhension de l'invention. On désire ici définir la densité des électrons ou des porteurs de charge que comporte le bloc. Sur la figure 6, le bloc 1 représente une faible partie d'un canal semi-conducteur qui est soit implanté, soit induit dans un substrat semi-conducteur au moyen de techniques bien connues. La densité des porteurs de charge sera définie en termes de densité volumétrique. Soit:

$N_x$ = le nombre de porteurs de charge ou d'ions que comporte le bloc dans la direction x,
$N_y$ = le nombre de porteurs de charge ou d'ions que comporte le bloc dans la direction y, et
$N_z$ = le nombre de porteurs de charge ou d'ions que comporte le bloc dans la direction z.

On peut supposer qu'il existe un intervalle moyen entre les porteurs de charge, les électrons ou les ions contenus dans le bloc 1 dans n'importe quelle direction et que cet intervalle est égal à une distance définie comme étant la distance d.

Le nombre total de porteurs de charge, d'électrons ou d'ions, ainsi qu'ils peuvent être diversement appelés, qui existent dans le bloc 1 de la figure 6, lequel ne constitue qu'une faible partie du canal conducteur dans un substrat donné, est donné par la relation suivante:

$$N_{total} = N_x N_y N_z = \frac{WLT}{d^3} \tag{1}$$

Or,

$$\frac{1}{d^3}$$

peut être défini comme étant égal à $N_D$, la concentration de donneurs qui est le nombre d'ions de porteurs de charge ou d'électrons par unité de volume à l'intérieur du bloc 1 existant dans le canal conducteur d'un substrat. La relation (1) peut donc s'écrire:

$$N_{total} = N_D WLT \tag{2}$$

La densité D des électrons, des porteurs de charge ou des ions dans un segment du plan x-y de la figure 6 existant dans une couche d'épaisseur T est définie par la relation suivante:

$$D = \frac{N_{total}}{WL} = N_D T \qquad (3)$$

d'où, en extrayant $N_D$:

$$N_D = \frac{D}{T} \qquad (4)$$

On déterminera ensuite le courant de canal $I_c$ qui traverse le bloc 1 de la figure 6.

Un faisceau de courant électrique $I_B$ d'une largeur égale à une seul électron est défini comme étant la variation de charge par unité de temps, dq/dt. Cela correspond au courant pris dans l'un des axes de la figure 6 et l'on supposera pour les besoins de la présente description que ce courant $I_B$ existe le long de l'axe y sur la figure 6. En conséquence, le courant $I_B$ peut être défini comme suit:

$$I_B = \frac{dq}{dt} = \frac{dq}{dy} \; \frac{dy}{dt} \qquad (5)$$

Cela peut également s'exprimer sous une autre forme, à savoir: le courant $I_B$ est égal à la charge unitaire q d'un électron multipliée par la vitesse $V$ du porteur de charge divisée par l'espacement d entre porteurs de charge successifs. En effet on a:

$$\frac{dq}{dy} = q/d \qquad et \qquad dy/dt = V \qquad (6)$$

Donc:

$$I_B = \frac{q}{d} \; V \qquad (7)$$

où $V$ est la vitesse moyenne des porteurs le long de l'axe y de la figure 6 et d est l'espacement moyen entre les porteurs qui constituent le faisceau d'électrons dirigé le long de l'axe y de la figure 6. La relation (7) ci-dessus définit le courant effectif d'un faisceau d'une largeur d'un seul électron se déplaçant dans la direction y. Pour étendre ce faisceau à une feuille de courant dans toute la largeur du bloc selon l'axe x de la figure 6, on peut définir comme suit le courant de feuille $I_S$ d'une unique couche d'électrons traversant une telle surface:

$$I_S = I_B N_X$$

ou

$$I_S = I_B \; \frac{W}{d} = \frac{q}{d} \; \frac{W}{d} \; V \qquad (8)$$

Cela équivaut à dire qu'une feuille de courant se déplaçant dans la direction y est égale au courant $I_B$ multiplié par le nombre d'électrons répartis le long de l'axe x et se déplaçant dans la direction y dans cette feuille, soit W divisé par l'espacement d entre électrons.

Le courant de canal total $I_c$ qui se déplace dans une direction donnée sur la figure 6 est égal au courant de feuille $I_S$ multiplié par le nombre d'électrons ou de porteurs distribués dans l'axe z sur une épaisseur T pour donner le courant volumétrique total. Pour un courant de canal, se déplaçant le long de l'axe y sur la figure 6, on a $I_c = N_z I_S$. En remplaçant, dans cette dernière expression $N_z$ par

$$\frac{T}{d}$$

et $I_S$ par sa valeur donnée par l'expression (8) on obtient:

$$I_c = \frac{T}{d} \; \frac{q}{d} \; \frac{W}{d} \; V.$$

6

**0 000 318**

Puisque

$$\frac{1}{d^3} = N_D$$

on obtient:

$$I_c = N_D \, TWqV \tag{9}$$

où T est l'épaisseur du canal dans l'axe z.

On a précédemment défini la densité D des porteurs dans une section plane d'épaisseur T Comme étant égale à la densité volumétrique des porteurs $N_D$ multipliée par l'épaisseur du bloc, (voir relation (3) ci-dessus). Après substitution, la relation (9) devient donc:

$$I_c = DWqV \tag{10}$$

Cela revient à dire que le courant de canal total est égal au produit de la densité des porteurs par la largeur du canal, par la charge unitaire q et par la vitesse $V$ des porteurs.

Le terme $V$ peut être exprimé en supposant qu'il existe dans le canal un champ électrique longitudinal uniforme dans le sens du déplacement des porteurs de charge. Cette supposition créée effectivement une approximation du premier ordre du champ électrique effectif qui existe dans le canal dans le sens du déplacement des porteurs comme suit: si le champ électrique existant est désigné $E_L$ et la mobilité des porteurs $\mu$ la vitesse $V$ est définie comme étant le produit du champ électrique $E_L$ par la mobilité $\mu$. Une approximation du champ électrique existant dans un dispositif à canal conducteur de la classe décrite peut être obtenue, dans le cas d'un canal semi-conducteur pourvu d'un drain et d'une source, en divisant la tension $V_{DS}$ (c'est-à-dire la tension entre le drain et la source) par la distance L séparant le drain de la source. Par conséquent:

$$E_L = \frac{V_{DS}}{\phantom{xx}}$$

et,

$$V \simeq \mu \, \frac{V_{DS}}{L} \tag{11}$$

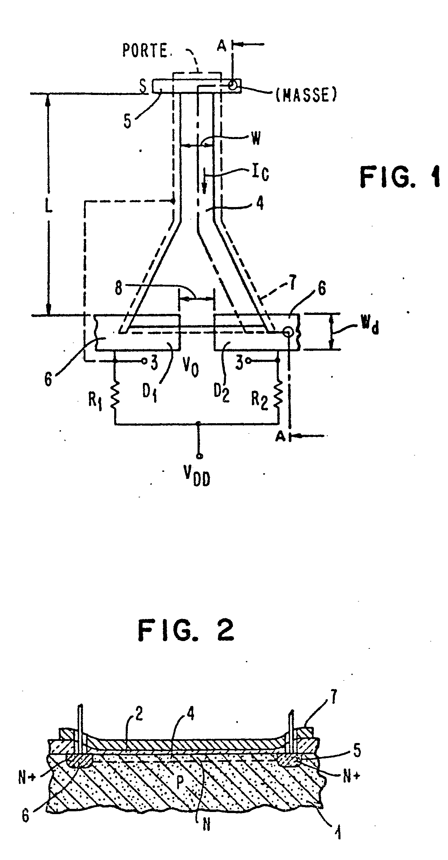

Les principes rappelés ci-dessus vont à présent être appliqués à un détecteur Vinhall typique dont une vue de dessus est représentée sur la figure 1. Ce détecteur comporte un canal de longueur totale L et de largeur totale (dans la région où le faisceau électronique est engendré) W, et possède une source S et au moins deux drains $D_1$ et $D_2$ qui existent à la surface d'un substrat en matériau semi-conducteur ou sont enterrés au-dessous de celle-ci. Sur la figure 1, une source typique 5 qui serait connectée, par exemple, au potentiel de la masse est représentée à l'une des extrémités d'un canal conducteur 4 dont la largeur et la longueur viennent d'être décrites et qui se termine par all moins deux drains mutuellement exclusifs 6 ($D_1$ et $D_2$). Les drains 6 sont connectés à un circuit de sortie par l'intermédiaire de résistances $R_1$ et $R_2$ de manière à produire une tension de sortie $V_o$ aux bornes 3. Les drains 6 sont connectés à une source de tension de drain $V_{DD}$ et la tension entre les drains 6 et la source 5 que l'on appellera $V_{DS}$ doit être maintenue à une valeur inférieure à celle à laquelle une ionisation par impact se produit.

Sur la figure 1, une porte métallique ou un écran électrostatique 7 représenté en pointillé recouvre le canal conducteur 4. on sait que, dans le mode de fonctionnement dit d'enrichissement des dispositifs semi-conducteurs à effet de champ, une porte est employée pour induire une densité des porteurs de charge suffisante pour former un canal conducteur entre la source et le ou les drains. Sur la figure 1, dans le cas d'une technologie faisant appel à l'emploi de silicium, un potentiel d'environ 10 volts, par exemple, serait utilisé aux fins du fonctionnement de la porte 7.

On notera que la partie du canal 4 qui se trouve à proximité des drains 6 est plus large que dans la région de la source 5. Cela est dû au fait que, dans la présente réalisation, la résolution que permettent d'obtenir les techniques actuellement employées pour réaliser un canal semi-conducteur a été poussée à l'extrême. En conséquence, la largeur W, bien qu'elle ne soit pas représentée à l'échelle sur la figure, constitue la limite extrême de la résolution que les techniques actuelles permettent d'obtenir. La largeur $W_d$ des drains 6 est approximativement égale à la largeur W. Etant donné que l'on désire que le canal 4 soit aussi étroit que possible, la largeur de la région des drains ne peut être réduite davantage étant donné qu'elle se trouve à la limite de la résolution. Il convient donc d'élargir le canal 4 dans la partie de celui-ci où il est relié aux drains 6 puisqu'il serait physiquement impossible de relier ces derniers à l'extrémité d'un canal de largeur W.

7

Ainsi qu'on le verra plus loin, d'autres raisons justifient l'élargissement du canal 4 à proximité des drains 6, mais on notera dès à présent que l'on désire que le canal 4 soit aussi étroit que possible et que les drains 6 soient aussi étroits que celui-ci et lui soient connectés de façon indépendante de telle sorte qu'ils soient séparés par une distance minimum 8. Etant donné que les techniques actuelles limitent la largeur du canal à une valeur W, la distance 8 qui peut être commandée avec précision sera aussi égale à W, bien qu'il existe des techniques permettant, ainsi qu'on le verra plus loin, de réduire cette distance. Cet évasement du canal 4 constitue également une configuration particulièrement souhaitable puisqu'elle permet de diminuer le bruit, d'augmenter la sensibilité et de supprimer d'autres problèmes potentiels comme on le verra plus loin.

On étudiera à présent les conditions et les caractéristiques de fonctionnement d'un dispositif du type représenté sur la figure 1.

En combinant les relations (3), (9) et (11), on obtient les relations suivantes qui définissent le courant de canal:

$$I_c = N_D T \left(\frac{W}{L}\right) q\mu \, V_{DS} \tag{12A}$$

ou

$$I_c = D \left(\frac{W}{L}\right) q\mu \, V_{DS} \tag{12B}$$

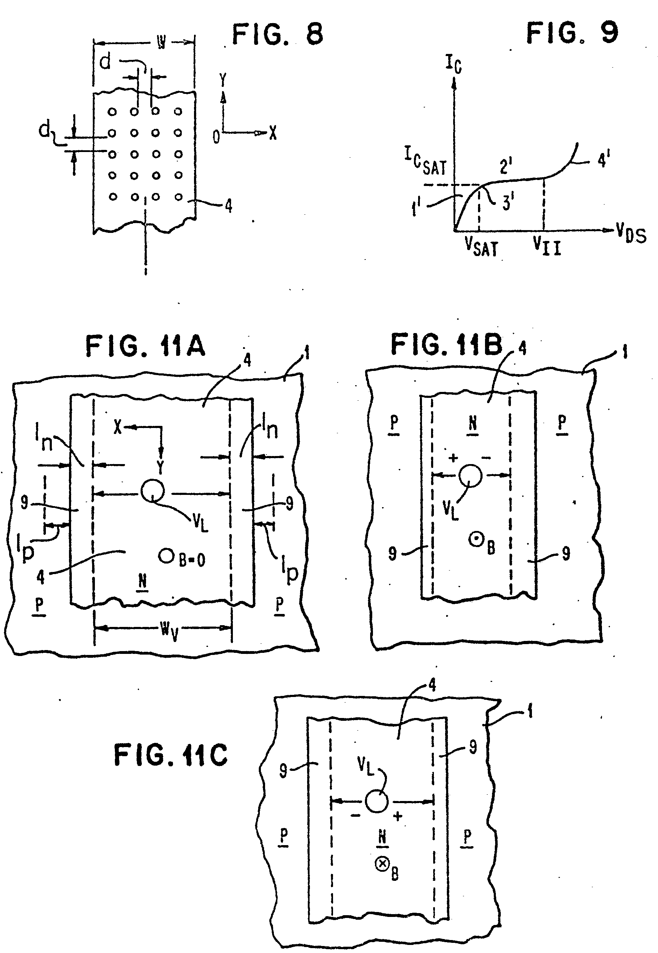

Les relations (12A) et (12B) ci-dessus définissent le courant de canal $I_c$ dans un dispositif du type représenté sur la figure 1. On sait que ce dernier présente une caractéristique de courant de canal telle que celle représentée par le graphique de la figure 9. Ce graphique est représentatif des transistors à effet de champ en général et présente plusieurs particularités bien connues telles que la région linéaire (1'), la région de saturation (2'), la région de pincement (3'), ainsi que la région d'ionisation par impact (4'). A partir du pincement, et malgré une augmentation de la tension entre le drain et la source, la conduction de courant n'augmente pas de façon importante jusqu'à ce que l'ionisation par impact, la rupture par avalanche ou d'autres phénomènes analogues se produisent à des tensions drain-source excessivement élevées $V_{II}$. Le courant de canal lors de la saturation ou du pincement où $V_{DS}$ est égale à $V_{SAT}$ est donc défini comme suit:

$$I_{c_{SAT}} = N_D T \left(\frac{W}{L}\right) q\mu \, V_{SAT} \tag{13A}$$

ou encore:

$$I_{c_{SAT}} = D \left(\frac{W}{L}\right) q\mu \, V_{SAT} \tag{13B}$$

Dans le cas des tensions drain-source qui, dans un canal, sont supérieures à la tension de pincement mais inférieures à la tension d'ionisation par impact, les équations de courant de canal sont les suivantes:

$$I_c = N_D \left(\frac{W}{L}\right) q\mu \, V_{SAT}\left(\frac{L}{L-L_D}\right) \tag{14A}$$

$$I_c = D \left(\frac{W}{L}\right) q\mu \, V_{SAT}\left(\frac{L}{L-L_D}\right) \tag{14B}$$

Dans les équations ci-dessus, L est la longueur totale du canal entre la source 5 et les drains 6. Comme le comprendra l'homme de l'art, une région de pincement peut être formée dans un dispositif à canal conducteur et cette région de pincement se formera à proximité des drains, créant ainsi une partie appauvrie de longueur $L_D$. La longueur effective de la partie non appauvrie du canal est donc ramenée à $L - L_D$.

Le détermination du courant de canal dans un dispositif à effet de champ ou dans un dispositif à canal conducteur est décrite dans la demande de brevet No. 77 16788 déposée en France par la demanderesse le 25 mai 1977 et rendue publique le 27 janvier 1978 sous le No. 2 357 073, (FR - A - 2 357 073) dans laquelle les termes

$$\frac{L}{L - L_D}$$

introduits dans les équations ci-dessus sont étudiés du point de vue de la connexité qui existe entre ces termes et le fonctionnement d'un tel dispositif. Il suffit de dire ici que la relation entre le courant de drain ou de canal et la longueur du canal divisée par la longueur totale non appauvrie restante (laquelle longueur s'étend jusqu'à la région de pincement) a été analysée théoriquement et vérifiée expérimentalement, les équations ci-dessus étant une représentation précise du fonctionnement du dispositif du type représenté sur la figure 1.

Lorsque le canal conducteur d'un dispositif tel que celui représenté sur la figure 1 est enterré au-dessous de la surface d'un substrat, une tension de pincement continue à exister mais doit être déterminée en fonction d'autres considérations. Ces dernières ne seront pas exposées ici de façon détaillée car on trouvera une approximation dans l'étude, par S.M. Sze, d'un transistor à jonction à effet de champ (J—FET) parue dans la publication intitulée *"Physics of Semiconductor Devices"*, pages 341 et suivantes. La tension de pincement pour un dispositif J—FET, désignée $V_{SAT}$ s'exprime sous une forme modifiée de la façon suivante:

$$V_{SAT} = 3\frac{qN_D T^2}{2e_s} = 3\frac{qDT}{2e_s} \tag{15}$$

Dans la relation (15) ci-dessus, $e_s$ est la constante diélectrique du matériau semi-conducteu utilisé. Dans le cas du silicium, $e_s$ est approximativement égale à $1{,}05 \times 10^{-10}$ Farads/m.

En substituant la relation (15) dans les relations (14A) et (14B) ci-dessus, on obtient:

$$I_c = 3 (N_D T)^2 q^2 T \left(\frac{W}{L}\right) \frac{\mu}{2e_s} \left(\frac{L}{L - L_D}\right) \tag{16A}$$

$$I_c = 3D^2\left(\frac{W}{L}\right) q^2 T \frac{\mu}{2e_s} \left(\frac{L}{L - L_D}\right) \tag{16B}$$

Les relations ci-dessus ayant été définies à partir des principes physiques fondefondamentaux qui caractérisent l'écoulement des porteurs de charge dans un dispositif à canal semi-conducteur, on s'efforcera à présent de définir les principes de fonctionnement d'un dispositif Vinhall et l'on appliquera ces derniers à un dispositif Vinhall et à un dispositif Hall à des fins de comparaison, puis l'on s'efforcera de déterminer les inexactitudes que comportent les considérations théoriques employées dans l'art antérieur.

On donnera à présent une description du détecteur Vinhall et de son mode de fonctionnement, après quoi on analysera ce détecteur en fonction des principes physiques auxquels il fait appel.

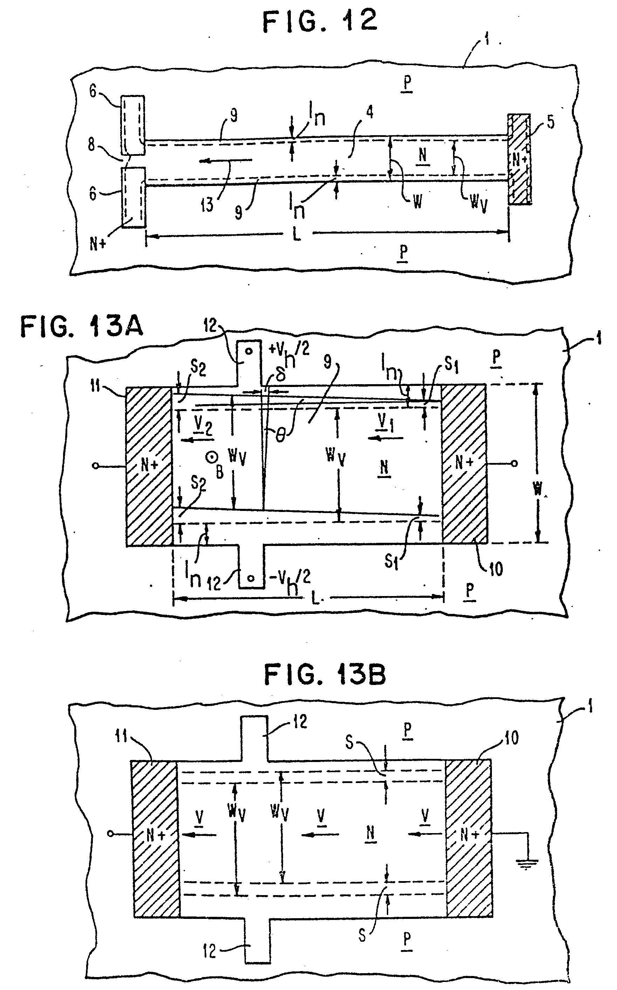

On a représenté sur la figure 12 un détecteur Vinhall typique fortement agrandi (cette représentation n'est pas à l'échelle). Le détecteur comporte un canal conducteur 4 ainsi qu'une source 5 et au moins deux drains 6 disposés, de la façon représentée sur la figure, aux extrémitées opposées du canal 4. Ce dernier a une longueur L et une largeur totale W. On supposera qu'un flux ou écoulement initial de porteurs 13, constitué en l'occurrence par des électrons, est injecté dans le canal 4 et se déplace directement au centre de celui-ci.

Dans l'art antérieur, l'étude des détecteurs magnétiques a été faite essentiellement à partir d'une théorie "balistique" de la déviation des électrons ou des porteurs par une force le Lorentz. Cette théorie veut d'autre part que les parois qui définissent les limites du canal et maintiennent l'écoulement d'électrons ou de porteurs à l'intérieur de celles-ci soient fixes et immuables. Par ailleurs, l'écoulement d'électrons serait dévié à l'intérieur du canal par la force de Lorentz appliquée aux porteurs en mouvement en présence d'un champ magnétique. Cette force provoquerait l'apparition sur les parois fixes du canal de "nuages" d'électrons et de trous qui créeraient un champ électrique, lequel s'opposerait à toute déviation ultérieure des électrons, et seraient à l'origine de ce que l'on a appelé "tension de Hall". L'étude ci-après montrera que ces considérations théoriques semblent erronées.

La figure 8 est une vue de dessus d'une partie d'un canal en matériau semi-conducteur 4. La partie de canal 4 a une largeur totale W et contient des électrons et d'autres porteurs présentant une configuration uniforme dans laquelle les porteurs sont séparés par un intervalle d dans les directions x et y. La partie de canal 4 a été placée sur un système d'axes x et y de telle sorte que l'axe y soit confondu avec l'axe de symétrie du canal et que les limites de ce dernier soient situées de part et d'autre de l'axe y à une distance $\pm$ W/2 de celui-ci.

Conformément à la théorie classique applicable aux dispositifs Hall, on a supposé que les parois du canal sont fixes et immuables, et il s'ensuit que si les électrons sont déviés dans le canal, ils doivent s'entasser le long d'une de ses parois, d'où un effet d'appauvrissement ou d'épuisement le long de la paroi opposée. Cet entassement supposé est produit par la force de Lorentz qui agit sur les porteurs qui se déplacent en présence d'un champ magnétique perpendiculaire à l'axe du canal et qui dévie les porteurs selon une trajectoire définie par le modèle balistique.

Pour voir le défaut de ce raisonnement, il suffit d'observer que la force électrostatique de répulsion entre mêmes charges (électrons) est trop grande pour qu'une déviation de quelque importance puisse être produite par une force de Lorentz. La force de Coulomb entre électrons uniformément espacés dans la direction x peut être définie comme suit:

$$F_x = \frac{q^2}{4\pi e_s x^2} \tag{17}$$

où x est l'intervalle entre électrons, $e_s$ est la constante diélectrique du milieu séparant les charges et q est la charge unitaire d'un électron.

La force $F_x$ appliquée à un électron par un champ électrique $E_x$ est également définie par:

$$F_x = qE_x \tag{18}$$

Les relations (17) et (18) permettent de déterminer le champ électrique $E_x$ qui existe entre les électrons:

$$E_x = \frac{q}{4\pi e_s x^2} \tag{19}$$

Il est intéressant de déterminer de quelle distance l'un de ces électrons peut se déplacer dans la direction x par suite du champ de Lorentz appliqué dans cette direction à un porteur de charge qui se déplace en présence d'un champ magnétique. Le champ de Lorentz dans la direction x peut s'exprimer par $dE_x = VB$ (où B est l'induction du champ magnétique).

En dérivant la fonction $E_x$ par rapport à x dans la relation (19), on obtient:

$$\frac{dE_x}{dx} = -\frac{q}{2\pi e_s} \frac{1}{x^3} \tag{21}$$

Pour un espacement x des électrons égal à d, on a:

$$\frac{1}{x^3} = \cdot N_D = \frac{1}{d^3}$$

est la définition standard de la concentration de donneurs dans un canal ou dans un matériau semi-conducteur.

On peut donc écrire la relation (21) sous la forme suivante:

$$\frac{dE_x}{dx} = -\frac{q}{2\pi e_s} N_D \tag{22}$$

En tirant $\Delta x$ de la relation (22), et en remplaçant $dE_x$ par sa valeur $V_B$ on obtient:

$$|\Delta x| = \frac{2\pi e_s VB}{qN_D} \tag{23}$$

En prenant les valeurs numériques suivantes:

$V$ = $10^7$ cm/s, ce qui est la vitesse maximum qu'un porteur est susceptible d'atteindre,

$e_s$ = $1{,}05 \times 10^{-12}$ farads/cm, en supposant que le matériau employé est du silicium,

$B$ = $350 \times 10^{-8}$ webers/cm², ce qui correspond à 350 Gauss cette valeur étant la valeur maximum du champ magnétique qui existe en principe immédiatement au-dessus de la surface d'une bande magnétique, par exemple,

**0 000 318**

$q = 1{,}6 \times 10^{-19}$ coulombs charge unitaire d'un électron,
$N_D = 10^{17}$ ions/cm³,
le champ de Lorentz $V_v B$, obtenu en pareil cas existe le long de l'axe x et est d'environ 35 volts/cm.
On obtient: $\Delta x = 1{,}44 \times 10^{-8}$ cm soit 0.144 nm (1,44 A).

Cette distance de déviation $\Delta x$ correspond à une tension de Hall qui est inférieure d'au moins un ordre de grandeur à celle effectivement obtenue dans le cas d'un dispositif de Hall utilisé dans les conditions indiquées ci-dessus. La théorie selon laquelle les parois du canal d'un dispositif Hall sont fixes et immuables semble donc être incorrecte. Le champ de Lorentz ne provoque pratiquement aucune déviation des porteurs de charge et aucun "entassement" ou "nuage chargé" d'électrons ne peut en résulter, même dans les conditions les plus favorables.

Le principe ci-dessus, dont on peut démontrer l'inexactitude, conduit à une conclusion inexacte. Par exemple, on affirme généralement qu'il est extrêmement souhaitable que le canal soit large afin d'éviter un entassement des charges. Etant donné que les champs de Lorentz ne peuvent pratiquement pas dévier les électrons dans les dispositifs de l'art antérieur, ainsi qu'on l'a démontré, le caractère fixe et immuable des parois du canal est erroné. Ainsi qu'on va maintenant le démontrer, ce n'est pas la largeur du canal, mais le processus de modulation, du fait de l'action de champs magnétiques ou électriques, de la largeur des régions d'appauvrissement qui constitue le facteur essentiel.

A titre d'exemple, on a représenté sur la figure 11A une partie du canal 4 qui est formée dans un substrat semi-conducteur 1. Ce dernier est du type P et le canal est du type N. La source 5 et les drains 6 ne sont pas représentés. Cette source et ces drains seraient du type $N^+$ et réalisés au moyen de techniques bien connues de manière à obtenir un dispositif fonctionnant dans le mode d'enrichissement ou dans le mode d'appauvrissement.

On observera que des jonctions P—N existent le long des limites du canal, ainsi qu'au niveau de la source et des drains partout où le matériau de type $N^+$ aboute le substrat de type P.

Ainsi qu'on le verra plus loin, il existe une région d'appauvrissement à toutes les jonctions P—N du dispositif, y compris sa partie inférieure, ses côtés, ses extrémités et, dans certains cas, la partie supérieure du canal conducteur lui-même. L'analyse ici donnée est limitée à une vue bidimensionnelle qui ne tient pas compte de la modulation en profondeur des régions d'appauvrissement dans les parties supérieure et inférieure du canal. Cette simplification n'affecte pas de façon appréciable la compréhension due mécanisme de l'invention. On notera cependant qu'il conviendrait de modifier légèrement les expressions relatives à la modulation de la largeur de la région d'appauvrissement aux fins d'une analyse tri-dimensionnelle.

On sait qu'une couche d'appauvrissement se forme aux jonctions P—N. Sur la figure 11A, les couches d'appauvrissement formées à l'intérieur du canal 4, le long des côtés de celui-ci, sont représentées en pointillés et désignées par le numéro de référence 9. La largeur des zones d'appauvrissement est identifiée soit par $ln_L$ ou $ln_R$, respectivement pour la largeur de la couche de gauche ou celle de droite, soit simplement par ln si les largeurs des couches de gauche ou de droite sont égales. Une couche analogue, de largeur $l_p$, existe dans le matériau de type P le long des côtés du canal. On notera que les électrons ne se déplacent que dans la partie non appauvrie du canal, partie dont la largeur est dite ci-après "largeur Vinhall" $W_v$ et est définie par:

$W_v = W - 2 l_n$ dans le cas où les largeurs des zones d'appauvrissement gauche et droite sont égales,
ou par
$W_v = W - (ln_L + ln_R)$ dans le cas où les largeurs des zones d'appauvrissement ne sont pas égales.

Dans les relations ci-dessus W représente la largeur physique du canal.

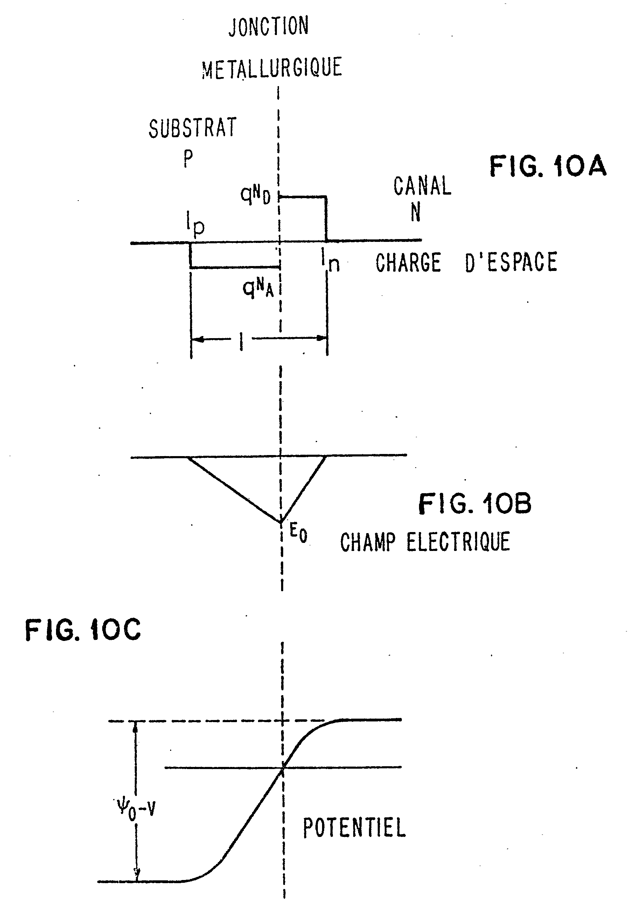

Un potentiel de la charge d'espace, un champ électrique et une tension existent, à proximité d'une jonction P—N entre le canal et le substrat. Les figures 10A, 10B, 10C représentent respectivement lesdits potentiel de charge d'espace, champ électrique et tension.

Les figures 10A à 10C sont alignées sur un axe vertical désigné "jonction métallurgique". Cette jonction est également dite limite stochastique ou partie de la jonction P—N où les concentrations de donneurs et d'accepteurs sont égales. Sur la figure 10A, la charge d'espace est représentée sous la forme d'une charge positive et d'une charge négative distribuées autour de la jonction métallurgique, la charge positive se trouvant dans la région de type N et la charge négative dans la région de type P. La nature de la distribution de cette charge d'espace n'est pas parfaitement comprise et n'est représentée que sous la forme d'une approximation grossière sur la figure 10A. Seules des observations d'un caractère général peuvent donc être formulées à partir de cette figure. Premièrement, des régions d'appauvrissement de largeurs différentes $l_p$ et $l_n$ existent respectivement dans les matériaux de type P et de type N en fonction, respectivement, des concentrations d'accepteurs et de donneurs. Deuxièmement, l'importance de la charge d'espace dans lesdites régions est le produit de la densité de donneurs $N_D$ par la charge des porteurs q soit $qN_D$. De même, dans la région de type P, la densité des accepteurs est égale au produit de $N_A$ par la charge électrique q soit $qN_A$. Selon la convention choisie en ce qui concerne le signe de la charge, la charge d'espace dans la région de type P est de signe plus ou de signe moins, et celle de la région de type N est de signe moins ou de signe plus, respectivement. Selon la convention ici choisie, la charge est positive dans la région de type N et négative dans la région de type P.

11

La figure 10B représente le champ électrique qui existe entre les bords de la région d'appauvrissement dans le matériau de type P et le matériau de type N au travers de la jonction métallique ou limite stochastique. Ce champ électrique peut être déterminé en appliquant la loi de Gauss à la distribution de la charge d'espace représentée sur la figure 10A. Au niveau de la jonction métallurgique ce champ a pour valeur $E_o$ qui s'exprime par:

$$E_o = - \left[ \frac{2q}{e_s} (\psi_o - V) \frac{N_D N_A}{N_D + N_A} \right]^{1/2}$$

Dans cette expression de $E_o$:

$\psi_o$ est le paramètre connu sous le nom de "tension de diffusion" et a pour valeur

$$\psi_o = \frac{KT_o}{q} \, \text{Log} \, \frac{N_A N_D}{N_i} \tag{24}$$

où K est la constante de Bolzmann, $T_o$ la température de Kelvin, $N_i$ est la concentration de porteurs intrinsèque dans le substrat ($N_i^2 = 10^{27}$), $N_A$ est la concentration d'accepteurs dans la matériau du substrat entourant le canal et $N_D$ la concentration de donneurs dans le canal.

V est la tension appliquée à la jonction $e_s$ et q sont respectivement la constante diélectrique du matériau considéré et la charge unitaire des électrons.

Cette expression de $E_o$ permet d'obtenir par intégration la valeur pour le potentiel qui est représenté sur la figure 10C. Ce potentiel est intéressant parce qu'il régit la largeur de la région d'appauvrissement qui existe de chaque côté de la limite stochastique et doit être parfaitement compris avant qu'une expression de la modulation de la largeur des régions d'appauvrissement puisse être définie.

L'expression ci-après permet d'obtenir une valeur approximative de la largeur $1_n$ de chaque région d'appauvrissement que comporte le canal 4:

$$1_n = \left[ \frac{2e_s}{q} (\psi_o - V) \frac{N_A}{N_A + N_D} \frac{1}{N_D} \right]^{1/2} \tag{25}$$

où la tension V est appliquée de façon externe à une jonction P—N.

L'obtention d'une valeur précise est fonction de la distribution effective de la charge d'espace (donneurs et accepteurs) qui serait formée à proximité immédiate des jonctions métallurgiques constituant les limites des régions d'appauvrissement. La forme et la distribution de ces régions sont actuellement inconnues. L'expression donnée ci-dessus est la meilleure dont on dispose actuellement (voir l'ouvrage de P.E. Gray et al, intitulé "Physical Electronics and Circuit Models of Transistors", publié en 1964 par John Wiley and Sons, New York, pages 8 à 23).

Ainsi qu'on l'a déjà indiqué, la largeur effective de la partie conductrice du canal est égale à la largeur W moins deux fois la largeur des régions d'appauvrissement. La largeur Vinhall $W_v$ précédemment définie peut également s'écrire, pour un état de repos à une tension donnée V et dans le cas où les largeurs des régions d'appauvrissement sont égales:

$$W_v = W_a - 2 \left[ \frac{2e_s}{q} (\psi_o - V) \frac{N^A}{N_A + N_D} \frac{1}{N_D} \right]^{1/2} \tag{26}$$

Il ressort de l'expression (25) que la largeur de la couche d'appauvrissement $1_n$ qui se trouve le long de chaque côté du canal est fonction d'une tension V de modulation de la largeur de cette couche qui est appliquée de façon externe à la jonction. Cette tension peut être créée à l'intérieur du canal par suite du champ de Lorentz $VB$ qui est formé dans un canal de largeur Vinhall $W_v$. La tension de Lorentz $V_L = VBW_v$ est dirigée dans la direction x, en supposant que les porteurs se déplacent dans le canal dans la direction y et qu'un champ magnétique soit appliqué perpendiculairement au canal.

La figure 11A représente la création et l'application de la tension de Lorentz $V_L$ qui agit dans la direction x vers les limites des régions d'appauvrissement qui se trouvent le long des côtés du canal. La définition générale de la tension de Lorentz $V_L$ est donnée sous la forme d'une intégrale curviligne du champ de Lorentz

$$V_L = \int_{-\frac{W_v}{2}}^{+\frac{W_v}{2}} V_y \times B_z \, . \, dx$$

prise entre les jonctions P—N qui forment les côtés du canal. Les couches d'appauvrissement 9 sont représentées sur la figure 11A avant l'application d'un champ magnétique perpendiculairement au plan de cette figure. De ce fait, on a indiqué que l'induction magnétique B est nulle.

Si un champ magnétique est appliqué au canal 4 perpendiculairement au plan de la page, ou obtient une tension de Lorentz qui, conformément à l'expression (25) ci-dessus, modifie la largeur $l_n$ des régions d'appauvrissement 9 le long de chaque côté du canal 4. Sur la figure 11B, l'induction magnétique sort du plan de la page et du fait de la modulation de la largeur des couches d'appauvrissement, les limites de ces dernières se déplacent toutes deux vers la gauche d'une même quantité réduisant de ce fait la largeur $ln_L$ et augmentant corrélativement la largeur $ln_R$ de la même quantité. Cela se traduit par un déplacement effectif, vers la gauche, de la partie conductrice du canal, sans variation de la largeur $W_v$. La situation inverse est représentée sur la figure 11C, l'induction B étant inversée et les limites des régions d'appauvrissement sont décalées d'une même quantité vers la droite. On notera que la largeur Vinhall $W_v$ reste constante et est indépendante du champ de Lorentz $VxB$. le phénomène décrit ci-dessus est particulièrement intéressant puisque les limites, qui étaient censées être fixes, font en réalité l'objet d'un déplacement alors que les porteurs eux-mêmes contenus dans le canal ne peuvent pratiquement pas être déviés par le champ de Lorentz. Il est intéressant de calculer la relation approximative qui peut exister et de déterminer le déplacement des limites du canal, dans la direction x, lorsque la tension de Lorentz leur est appliquée.

En écrivant de nouveau l'expression (25) en y remplaçant le terme $\psi_0$ par sa valeur donnée par la relation (24) et en prenant une tension —V égale à

$$VBW_v \, Log\frac{N_A N_D}{N_I^2}$$

on obtient:

$$1_n = \left[ \frac{2e_S}{q} \left( \frac{KT_o}{q} + VBW_v \right) \left( \frac{N_A}{N_A+N_D} \right) \left( \frac{1}{N_D} \right) Log \left( \frac{N_A N_D}{N_I^2} \right) \right]^{1/2} \qquad (27)$$

On peut simplifier l'expression (27) en procédant aux substitutions suivantes et en négligeant les effets de la tension de drain en fonction de la position le long du canal et particulièrement à proximité des drains, oú le pincement se produit:

$$\alpha = \frac{2e_S}{q} Log \left( \frac{N_A N_D}{N_I^2} \right) \qquad (28)$$

$$\gamma = \left( \frac{N_A}{N_A + N_D} \right) \left( \frac{1}{N_D} \right) \qquad (29)$$

Ce qui donne:

$$1_n = \left[ \gamma \alpha \left( \frac{KT_o}{q} + VBW_v \right) \right]^{1/2} \qquad (30)$$

NOTE: Dans cette analyse, on n'a pas tenu compte des effets de la tension de drain en fonction de la position le long du canal. Cette expression résultante est valide à proximité du drain où le pincement se produit.

En dérivant la fonction $I_n$ par rapport à B dans l'expression (30), on obtient:

$$\frac{dI_n}{dB} = \frac{1}{2}\,\frac{\gamma\alpha}{I_n}\,VW_v \tag{31}$$

En remplaçant la valeur de $I_n$ donnée par l'expression (30) dans l'expression (31) on obtient:

$$\frac{dI_n}{dB} = \frac{1}{2}\sqrt{\frac{\gamma\alpha}{\dfrac{KT_o}{q} + VBW_v}}\,(VW_v) \tag{32}$$

En remplaçant $\alpha$ par sa valeur donnée par l'expression (28), on obtient:

$$\frac{dI_n}{db} = \frac{1}{2}\sqrt{\frac{2e_s\,\gamma\,\text{Log}\left(\dfrac{N_A N_D}{N_i^2}\right)}{KT_o + q\,VBW_v}}\,(VW_v) \tag{33}$$

En posant:

$$K_i = \frac{2e_s}{KT_o + qVBW_v}\,\text{Log}\left(\frac{N_A N_D}{N_i^2}\right) \tag{34}$$

on obtient:

$$\frac{dI_n}{dB} = \frac{1}{2}\sqrt{K_i\,\gamma}\,VW_v \tag{35}$$

En remplaçant $\gamma$ dans l'expression (35) par sa valeur dans l'expression (29) et en posant $S = \int dI_n$ comme valeur du déplacement des limites de la largeur de la région d'appauvrissement on obtient

$$S = \frac{1}{2}\sqrt{K_i\left(\frac{N_A}{N_A + N_D}\right)\left(\frac{1}{N_D}\right)}\,(VW_v dB)$$

ou

$$S = \frac{1}{2}\sqrt{K_i T\left(\frac{D_o}{D_o + D}\right)\left(\frac{1}{D}\right)}\,(VW_v dB) \tag{36}$$

Etant donné que: $N_D T = D$

$$N_A T = D_o$$

L'expression (36) définit le déplacement des limites des régions d'appauvrissement dans le cas d'un champ magnétique d'induction B. Ainsi, les deux limites sont décalées dans le même sens d'une distance S par suite de l'action exercée par le champ de Lorentz dans la direction x. Ceci a pour résultat de maintenir la largeur Vinhall, $W_v$, à une valeur constante, mais de déplacer la partie conductrice du canal, vers la gauche ou vers la droite, d'une distance S.

Il est intéressant de calculer la valeur de cette distance S en utilisant les mêmes hypothèses que dans le cas du modéle de déviation balistique. On obtient ainsi:

$$S = 6\ nm\ (60\ A)$$

pour

$$D_o = 3 \times 10^{11}\ V = 10^7\ cm/s$$

14

$D \quad = 2 \, \delta \, 10^{12} \, K_i = 6 \, \delta \, 10^9$

$T \quad = 200 \text{ nm } (2000 \text{ Å})$

$W_v = 3 \times 10^{-4} \text{ cm}$

On voit que le déplacement desdites limites est supérieur de 50 fois environ à celui précédemment obtenu.

On va maintenant déterminer la mesure dans laquelle le signal de sortie du dispositif Vinhall est affecté par le déplacement desdites limites d'une distance S.

Comme le montre la figure 12, deux drains 6 sont séparés par un faible intervalle 8. Ces drains se trouvent à l'extrémité gauche du canal 4 et captent évidemment la totalité du courant de canal qui n'est pas affecté par le champ magnétique. Toutefois, comme les drains 6 sont séparés l'un de l'autre et que l'application d'un champ magnétique provoque un déplacement vers le haut ou vers le bas, sur la figure 12, des limites du canal de la façon qui vient d'être décrite, des variations de courant différentielles sont obtenues au niveau des drains 6. On peut aisément démontrer, comme on le verra par la suite, que la sensibilité

$$\frac{\Delta I_c}{I_c}$$

du dispositif Vinhall est donnée par l'expression suivante:

$$\eta_v = \frac{\Delta I_c}{I_c} = \frac{2S}{W_v} \qquad (37)$$

En remplaçant S dans l'expression (37) par sa valeur dans l'expression (36), on obtient:

$$\eta_v = \sqrt{K_i \left(\frac{D_o}{D + D_o}\right) \frac{T}{D} \, VdB} \qquad (38)$$

Il est important de noter que la sensibilité $\eta_v$ du détecteur Vinhall est inversement proportionnelle à la largeur Vinhall $W_v$ si le produit $VBW_v$ est supérieur à

$$\frac{KT_o}{q}.$$

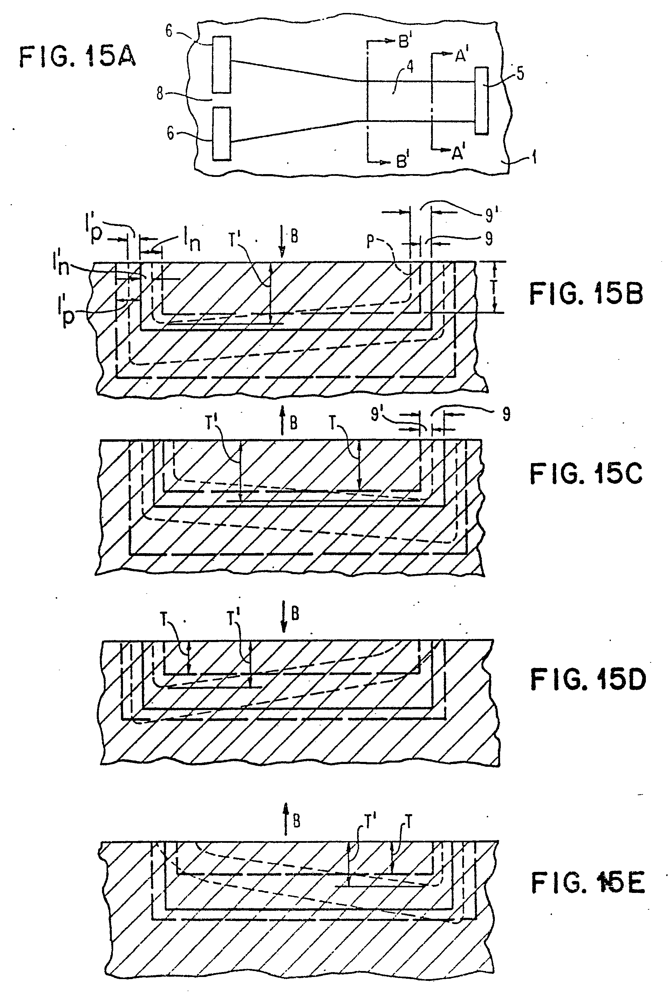

Il est très important également de tenir compte du fait que la forme de ces expressions est régie par l'expression choisie pour définir la longueur des régions d'appauvrissement qui se trouvent le long des côtés opposés de la jonction métallurgique. Ainsi qu'on l'a déjà mentionné, l'expression employée ne donne qu'une valeur approximative puisque la distribution effective des charges d'espace aux limites des régions d'appauvrissement est inconnue. Par ailleurs, l'analyse faite ci-dessus n'est que bidimensionnelle alors que la modulation de la largeur des régions d'appauvrissement est un phénomène tri-dimensionnel. A cet égard, on se reportera aux figures 15A à 15E.

La figure 15A est une vue de dessus d'un détecteur Vinhall typique qui comporte un canal 4 reliant une source 5 et des drains 6.

La figure 15B est une coupe du dispositif de la figure 15A prise selon la ligne A'—A'. On peut voir qu'il existe une limite statique des régions d'appauvrissement avant l'application au canal d'une induction magnétique B. A cette limite statique sont associées les largeurs $l_n$ et $l_p$ des régions d'appauvrissement qui existent respectivement dans les matériaux de type N et de type P. L'épaisseur T du canal est également indiquée. Lorsque l'induction magnétique B est dirigée vers le bas, de la façon indiquée par la flèche sur la figure 15B, il se produit une modification non seulement des largeurs $l_n$ et $l_p$, les nouvelles largeurs $l'_n$ et $l'_p$ étant indiquées sur la figure, mais aussi de l'épaisseur du canal, la nouvelle épaisseur étant référencée T'. On notera que la nouvelle épaisseur T' n'est pas uniforme et qu'elle est plus faible le long d'un des côtés du canal que de l'autre.

La situation inverse est représentée sur la figure 15C qui est aussi une coupe selon A'A', l'induction magnétique B étant dirigée vers le haut. Comme précédemment, les limites des couches 9' et la nouvelle épaisseur T' ont été indiquées en pointillé.

Les figures 15D et 15E sont des coupes du dispositif de la figure 15A prises selon la ligne B'—B'. Cette ligne B'—B' est plus proche des drains que ne l'est la ligne A'A'. On sait que, par suite de l'accroissement de la tension de drain qui se produit au fur et à mesure que l'on se rapproche des drains, l'épaisseur du canal diminue. L'épaisseur initiale T représentée sur les figures 15D et 15E est donc plus faible que sur les figures 15B et 15C. En revanche, les effets de l'induction magnétique B sont analogues à ceux représentés sur ces dernières figures. On notera que les effets de la modulation de la largeur et de l'épaisseur des régions d'appauvrissement se produisent simultanément dans le canal au niveau des coupes prises selon les lignes A'—A' et B'—B'. Les explications mathématiques de ces effets tri-dimensionnels sont extrêmement complexes. L'analyse ici présentée décrit uniquement le déplacement des parois et, en dépit de cette limitation, les résultats obtenus expérimentalement correspondent d'une façon très précise à la théorie.

Il va sans dire que des perfectionnements successifs devront être apportés aux expressions mathématiques données plus haut lorsqu'on disposera de données supplémentaires nouvelles ou plus précises en ce qui concerne la nature de la jonction métallurgique, les effets du pincement sur la géométrie du canal et la nature de la distribution de la charge despace dans cette jonction métallurgique. Néanmoins, ces problèmes n'affectent pas les observations générales faites ci-après car elles font appel à des rapports de résultats calculés et non à des résultats numériques absolus.

Comme le montre l'expression (38) et (34) ci-dessus, une sensibilité élevée peut être obtenue en diminuant la largeur totale du canal, de telle sorte que $BW/W_v$ soit inférieur ou égal à

$$\frac{KT_o}{q},$$

résultat complètement inattendu qui est en opposition directe avec l'art antérieur. En fait, on notera qu'il existe une relation réciproque entre les dispositifs Vinhall et Hall, ainsi qu'on le verra plus loin. La largeur Vinhall doit être faible et la largeur des couches d'appauvrissement doit représenter une proportion relativement importante de la largeur totale du canal de telle sorte qu'une déviation effective plus grande des limites des régions d'appauvrissement puisse être obtenue. On verra également que le fonctionnement d'un dispositif à effet Hall dépend de l'existence d'un gradient de la vitesse des porteurs et que l'on n'a, semble-t-il, pas découvert ce fait jusqu'à présent. Certaines contradictions entre les résultats constatés et la théorie antérieure de l'effet Hall semblent s'expliquer par le fait que les dispositifs utilisant l'effet Hall exigent un gradient de vitesse pour pouvoir fonctionner.

Avant de comparer une cellule à effet Hall et le détecteur Vinhall, on formulera un certain nombre d'expressions mathématiques importantes pour définir les performances dudit détecteur. Les expressions définitives essentielles, outre celles précédemment données qui définissent la sensibilité et le courant de canal, sont celles qui se rapportent au signal de sortie et au rapport signal/bruit.

A partir de l'expression (37) ci-dessus, qui constitue la définition fondamentale de la sensibilité d'un détecteur Vinhall, on peut définir de la façon suivante le signal de sortie et le rapport signal/bruit:

Un signal de sortie $\Delta E$ est défini comme étant égal á $R\Delta I$. Par conséquent, lorsque R est la résistance de charge et que $\Delta I$ est la variation du courant, I sera égal au courant de canal $I_c$ multiplié par la sensibilité $\eta_v$. De ce fait, le signal de sortie du détecteur Vinhall sera:

$$\Delta E = RI_c\eta_v \tag{39}$$

Les expressions (16A) et (16B) sont rappelées ci-dessous dans un but de commodite:

$$I_{c_{SAT}} = 3\,(N_D T)^2\,q^2T(\frac{W}{L})\,\frac{\mu}{2e_s}\,(\frac{L}{L-L_D}) \tag{16B}$$

ou

$$I_{c_{SAT}} = 3\,D^2(\frac{W}{L})\,q^2T\,\frac{\mu}{2e_s}\,(\frac{L}{L-L_D}) \tag{16A}$$

où $N_D$ est la concentration de donneurs dans le canal, T est l'épaisseur du canal, $W_v$ est la largeur Vinhall, $V_{SAT}$ est la vitesse de saturation des porteurs et correspond à $10^7$ cm/s, et D est la densité intégrée des électrons existant dans le canal.

En fonction de ce qui précède, le signal de sortie du détecteur Vinhall peut maintenant être obtenu en combinant les expressions (39), (38) et (16A) ou (16B) de la façon suivante:

$$\Delta E = R I_c \eta_v$$

$$\Delta E = \frac{3}{2}\, RDT^{3/2}\, \left(\frac{W}{L}\right)\, q^2\, \frac{\mu}{e_s}\, \sqrt{K_i\, \frac{D_o}{D_o+D}\, D}\; V_{SAT}dB \qquad (40)$$

pour

$$VW_v B \leq \frac{KT_o}{q}$$

L'expression (40) est formulée en termes de la densité D et non des concentrations d'accepteurs $N_A$ et de donneurs $N_D$. Il s'agit en l'occurrence d'un facteur particulièrement utile lorsqu'on désire fabriquer ces dispositifs, soit dans le mode de fonctionnement dit d'enrichissement dans lequel les porteurs forment un canal lors de l'application à la porte d'une tension de commande, soit dans le mode de fonctionnement dit d'appauvrissement dans lequel des techniques de dopage ou d'implantation ionique sont utilisées pour créer un canal dans le substrat. La densité cumulative est en général une variable connue alors que les concentrations d'accepteurs et de donneurs sont difficiles à déterminer avec précision.

Avant d'exprimer le rapport signal/bruit afférent au détecteur Vinhall, on évoquera brièvement le sujet du signal de bruit lui-même. En dehors du bruit statistique résultant des fluctuations de la densité ou de l'espacement des électrons dans le canal conducteur lui-même, il existe au moins trois autres sources de bruit dont les effets doivent être réduits au minimum. Tout d'abord il y a le bruit d'injection introduit à la source. Il s'agit en l'occurrence d'un bruit statistique de nature complexe qui est produit par des vitesses d'injection variables avec une distribution essentiellement Gaussienne à la source. Il suffit de dire ici que l'on peut réduire au minimum ce bruit statistique en utilisant un canal relativement long, c'est-à-dire un canal qui est long par comparison avec la largeur Vinhall $W_v$.

Un autre type de bruit est celui qui résulte de la dispersion des électrons du fait des irrégularités que comporte la surface supérieure du canal. Ce type de bruit peut être supprimé ou diminué en créant un canal enterré de telle sorte qu'aucune conduction importante ne puisse se produire à la surface du canal.

Un troisième type de bruit résulte du fait que les trajectoires des électrons peuvent s'incurver rapidement à proximité des drains. On peut réduire ou supprimer ce type de bruit en ramenant l'intervalle que sépare les drains à une valeur inférieure à la largeur Vinhall.

En supposant que toutes les mesures indiquées ci-dessus aient été prises pour réduire ou supprimer ces différents types de bruit, et que le bruit restant soit négligeable par rapport au bruit statistique, on peut raisonnablement considérer que le rapport signal/bruit est égal au signal de sortie du détecteur Vinhall divisé par le bruit statistique, ce qui donne le rapport de bruit statistique $\beta$ qui pour le dispositif Vinhall, est défini comme suit:

$$\beta = \frac{\Delta E_v}{E_N} = \eta_v\, \sqrt{\frac{I_c}{2\,\Delta f\, q}} \qquad (41)$$

où la tension de bruit $E_N$ est égale à:

$$E_N = R\, \sqrt{2qI_c\Delta f} \qquad (42)$$

$\Delta f$ étant la largeur de bande du signal en Hertz.

En remplaçant $I_c$ et $\eta_v$ dans l'expression (41) par leurs valeurs respectivement définies par les expressions (16A) et (38), on obtient:

$$\beta = V_s BT\, \sqrt{\frac{3/4\left(\dfrac{W}{L}\right) q\mu\, K_i\, \left(\dfrac{D_o}{D+D_o}\right) D}{e_s \Delta f}} \qquad (43)$$

pour

$$V_s BW_v \leq \frac{KT_o}{q}$$

**0 000 318**

Il ressort clairement de l'expression (43) et de la définition de $K_i$ précédemment donnée que le rapport signal/bruit est indépendant de la largeur Vinhall $W_v$ lorsque la condition critique

$$V_s BW_v \leq \frac{KT_o}{q}$$

est satisfaite, et dépend de l'épaisseur T du canal, des densités des électrons $D_o$ et D et de la vitesse de saturation des porteurs $V_s$.

On procèdera à présent à une comparaison du fonctionnement du dispositif Vinhall et de celui d'un dispositif Hall en utilisant comme base la nouvelle théorie proposée par la présente invention. On précisera tout d'abord les caractéristiques de fonctionnement d'un dispositif Hall en utilisant les principes de la modulation de la largeur des régions d'appauvrissement qui ont été précédemment exposés. Avant de définir les expressions afférentes au fonctionnement des dispositifs, on donnera une simple explication qualitative.

On se reportera à présent aux figures 13A et 13B qui représentent schématiquement une cellule à effet Hall typique. Dans la cellule représentée sur la figure 13A des porteurs sont injectés depuis une source 10 et sortent d'un drain 11 à l'extrémité opposée de la cellule. Deux sondes de sortie 12 sont disposées entre les extrémités de la cellule. Le courant circule directement dans le canal entre la source et le drain. Les porteurs qui sont injectés au niveau de la source entrent dans la cellule à une vitesse $V_1$ et en sortent à une autre vitesse $V_2$. Il existe donc un gradient de vitesse entre la source et le drain de la cellule représentée sur la figure 13A. Par suite de la modulation des limites des régions d'appauvrissement, lesquelles limites sont fonction de la vitesse, comme l'indique, par exemple, l'expression (36), ci-dessus, ces limites se déplacent de la façon indiquée sur la figure 13A et les lignes équipotentielles effectuent une légère rotation de manière à produire une tension de sortie aux sondes 12. On notera que la largeur Vinhall $W_v$ existe dans la cellule et reste essentiellement constante.

La figure 13B met en évidence le fait que le fonctionnement de la cellule dépend d'un gradient de vitesse. Sur cette figure, la cellule est analogue à celle de la figure 13A, mais les vitesses d'entrée et de sortie $V_1$ et $V_2$ sont égales et one une valeur V. On voit qu'en pareil cas, bien que les limites du canal puissent faire l'objet d'un déplacement du fait de la modulation de la largeur des régions d'appauvrissement, ce déplacement s'effectue parallèlement aux côtés du canal et il ne se produit aucune rotation des lignes équipotentielles. La cellule à effet Hall ne produira donc pas, dans le cas d'une vitesse constante des porteurs dans le canal, de signal de sortie.

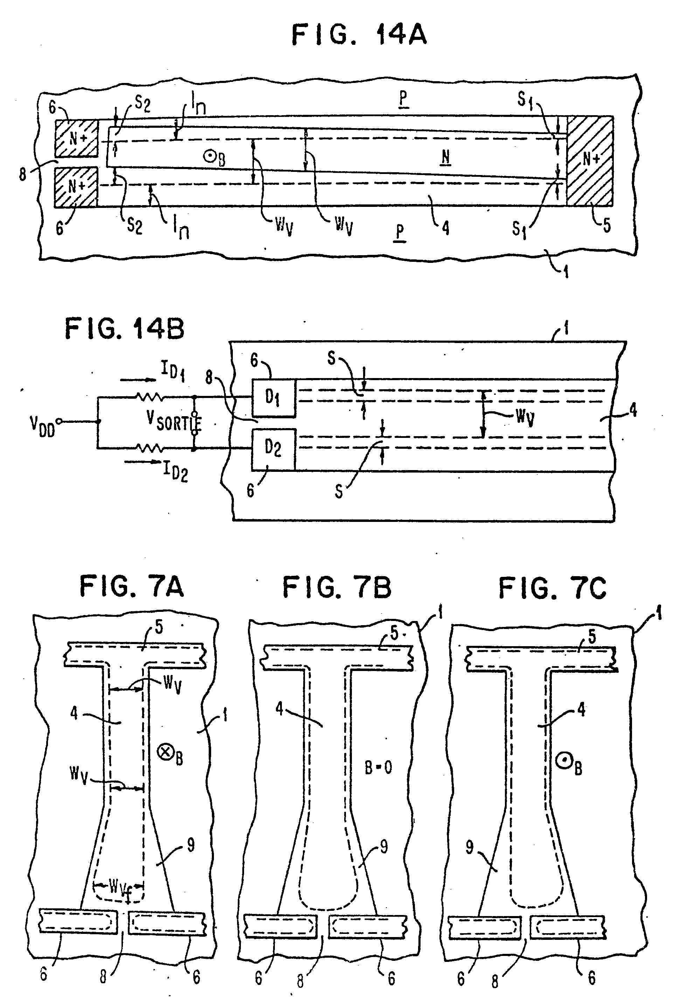

Sur la figure 13A, il est évident que la cellule à effet Hall fournira une sortie dans les conditions représentées puisque les lignes équipotentielles entre la source et le drain ont fait l'objet d'une rotation d'un petit angle $\theta$. En revanche, aucun signal de sortie ne sera obtenu dans le cas représenté sur la figure 13B puisque la vitesse des porteurs est constante dans le canal entre la source et le drain. Cette vitesse constante se traduit par une simple translation uniforme des limites des régions d'appauvrissement le long canal. Les lignes équipotentielles ne sont pas modifiées et, par conséquent, aucun signal de sortie ne doit théoriquement être obtenu. En revanche, dans les mêmes conditions, c'est-à-dire pour une vitesse uniforme des porteurs dans le canal, le dispositif Vinhall représenté sur la figure 14B fournit un signal substantiel $V_{SORTIE}$ entre les drains séparés 6. Cela est dû au fait que les drains D1 et D2 reçoivent un courant differentiel, ainsi qu'on l'a précédemment mentionné, parce qu'ils interceptent la quasi totalité du courant qui circule dans le canal.

Il ressort de ce qui précède que la génération d'une tension de sortie par un dispositif Hall dépend de l'existence d'un gradient de vitesse des porteurs $\nabla V$ dans le canal de manière à provoquer une rotation des lignes équipotentielles, de la façon indiquée sur la figure 13A. La sensibilité d'un tel dispositif, lorsque la vitesse des porteurs est constante, est pratiquement nulle, mais celle du détecteur Vinhall de la figure 14B dans les mêmes conditions peut aisément être calculée en considérant les courants de drain $I_{D1}$ et $I_{D2}$ respectivement obtenus aux deux drains D1 et D2.

A) $$I_{D1} = J \left(\frac{W_v}{2} + S\right) \tag{44A}$$

B) $$I_{D2} = J \left(\frac{W_v}{2} - S\right) \tag{44B}$$

C) $$\Delta I = I_{D1} - I_{D2} = 2JS \tag{44C}$$

D) $$I = I_{D1} + I_{D2} = JW_v \tag{44D}$$

où J est le courant par unité de largeur du canal. De ce fait:

18

$$\frac{\Delta I}{I} = \frac{I_{D1} - I_{D2}}{I_{D1} + I_{D2}} = \frac{2S}{W_v} \tag{45}$$

Les différences fondamentales entre un dispositif Hall et un dispositif Vinhall peuvent aisément être déterminées en procédant aux comparaisons ci-après.

Pour qu'on dispositif Hall puisse fonctionner, (1) il est indispensable qu'un gradient de vitesse existe dans le canal, et (2) la tension de sortie est fonction de la vitesse des porteurs et non de leur nombre.

Pour qu'un dispositif Vinhall puisse fonctionner, (1) aucun gradient de vitesse n'est nécessaire, (2) la tension de sortie est uniquement fonction de la vitesse des porteurs aux drains, et (3) la tension de sortie est fonction du nombre de porteurs qui pénètrent dans la région des drains avec une vitesse déterminée.

On peut maintenant procéder à une comparaison entre les deux types de dispositif en fonction de leur performance et de leurs caractéristiques de sortie. Le principal objet de cette étude est de déterminer le rapport de sensibilité $R_o$ entre les dispositifs Vinhall et Hall. Le résultat de cette étude est indépendant de l'expression définissant la modulation de la largeur des régions d'appauvrissement qui a été indiquée ci-dessus puisque, dans cette étude, le rapport entre les sorties sera utilisé et que les modulations des largeurs des régions d'appauvrissement sont les mêmes dans les deux dispositifs. On supposera que la vitesse des porteurs augmente le long du canal de la source vers le drain afin de simplifier les calculs, et la vitesse des porteurs dans le canal sera déterminée au moyen de l'approximation suivante:

$$V(y) = V_1 + (V_2 - V_1) \frac{Y}{L} \tag{46}$$

où $V_1$ est la vitesse des porteurs au niveau de la source et $V_2$ est la vitesse acquise par les porteurs au niveau des drains. La largeur $I_n$ des régions d'appauvrissement est modulée à la source d'une distance $S_1$ et aux drains d'une distance $S_2$ et, d'une façon générale, à une distance quelconque Y le long du canal de la façon indiquée par les expressions (47A), (47B) et (48) qui définissent respectivement le déplacement au niveau de la source, le déplacement au niveau du drain et le déplacement en fonction de la distance le long du canal:

$$S_1 = \sqrt{k\,V_1} \tag{47A}$$

$$S_2 = \sqrt{k\,V_2} \tag{47B}$$

$$S(y) = \sqrt{k\,\left(V_1 + (V_2 - V_1)\frac{Y}{L}\right)} \tag{48}$$

où

$$k = \frac{e_s}{q} W_v B \frac{N_A}{N_D\,(N_A + N_D)} \tag{49}$$

Dans le cas représenté sur la figure 13A, le petit angle $\theta$ est l'angle dont la tangente est égale à

$$\frac{S_2 - S_1}{L}$$

Cette valeur est égale à la déviation latérale $\delta$ à l'une des extrémitiés d'une ligne équipotentielle divisée par la largeur $W_v$ du canal, d'où:

$$Tg\,\theta = \frac{S_2 - S_1}{L} = \frac{\delta}{W_v},$$

où

$$\delta = \frac{W_v}{L}\,(S_2 - S_1) \tag{50}$$

19

Comme approximation du premier ordre de la tension de Hall $V_h$, on peut considérer que, la rotation des lignes équipotentielles étant définie par l'expression (50), la tension $V_h$ sera la proportion de la différence de potentiel $V_0$ entre la source et le drain qui est obtenue en décalant les sondes d'une distance $\delta$, c'est-à-dire:

$$V_h = \frac{V_0 \delta}{L} \tag{51}$$

Des expressions (50) et (51), on tire:

$$V_h = V_0 \frac{W_v}{L^2}(S_2 - S_1) \tag{52}$$

En remplaçant $S_1$ et $S_2$ par leur valeur dans les expressions (47A) et (47B), l'expression (52) devient:

$$V_h = V_0 \frac{W_v}{L^2} \sqrt{kV_2} - \sqrt{kV_1} \tag{53}$$

Il ressort clairement de cette dernière expression que la tension $V_h$ sera théoriquement nulle si aucune variation de la vitesse des porteurs ne se produit dans le canal, c'est-à-dire, $V_h = 0$ si $V_2 = V_1$. Il apparaît donc qu'un dispositif Hall ne peut fonctionner que s'il existe un gradient de vitesse dans le canal. Pour les besoins de l'étude précitée, on utilisera les conditions nécessaires pour obtenir la tension $V_h$ maximum et l'on comparera les signaux de sortie résultants. Ce résultat peut être obtenu en faisant en sorte que la vitesse d'injection $V_1$ soit nulle dans les deux dispositifs, que la vitesse ultime des porteurs soit la vitesse maximum $V_2$ correspondant à un pincement, et qu'une augmentation linéaire de vitesse se produise en fonction de la distance Y dans le canal en se dirigeant vers les drains. Dans ce cas, la tension de sortie devient:

$$V_h = V_0 \frac{W_v}{L^2} \left[ \sqrt{kV_2} \right] \tag{54}$$

La sensibilité $\eta_H$ du dispositif Hall, qui est

$$\frac{V_h}{V_0},$$

est obtenue en divisant l'expression (54) par $V_0$, la tension appliquée entre la source et le drain du dispositif. Cela donne le résultat suivant:

$$\eta_H = \frac{V_h}{V_0} = \frac{W_v}{L^2}\sqrt{kV_2} \tag{55}$$

La sensibilité $\eta_V$ du dispositif Vinhall est déterminée en imaginant que le drain représenté sur la figure 13A se compose en fait de deux drains séparés par un intervalle 8 comme sur la figure 12. La sensibilité $\eta_V$ devient, puisqu'elle est définie, comme précédemment, par

$$\frac{2S}{W_v},$$

où $S = S_1 + \Delta S$ et où $\Delta S = S_2 - S_1$, ces deux derniers termes étant définis par les expressions (47A) et (47B):

$$\eta_V = \frac{2S_1}{W_v} + \frac{2\Delta S}{W_v} = \frac{2S_2}{W_v} = \frac{2}{W_v}\sqrt{kV_2} \tag{56}$$

Le rapport de sensibilité $R_0$ qui est défini ci-dessous permet de comparer la sortie du dispositif

**0 000 318**

Vinhall avec celle du dispositif Hall et est obtenue en divisant la relation (56) par la relation (55), ce qui donne:

$$R_o = 2(\frac{L}{W_v})^2 = \frac{\eta_v}{\eta_H} \tag{57}$$

L'expression (57) ci-dessus est valable pour les conditions équivalentes de fonctionnement des deux dispositifs dans lesquelles une chute de tension égale à la moitié du courant de canal multipliée par la résistance de charge $R_L$ se produit dans cette dernière, créant ainsi une tension $V_0$ identique à la tension de commande $V_0$ appliquée aux bornes du dispositif Hall.

Cela peut s'écrire:

$$V_{SAT} = \frac{I}{2} I_{C_{SAT}} R_{L'}$$

expression dans laquelle:

$$I_{C_{SAT}} = V_{SAT} \ D \ [\frac{W_v}{L} \ q\mu].$$

Ainsi, en substituant l'expression relative à $I_{C_{SAT}}$, on obtient:

$$\frac{L}{W_v} = \frac{R_L D q\mu}{2}.$$

Ce critère spécifie que le rapport de la longueur L du canal à la largeur Vinhall $W_v$ est fonction de la résistance de charge, de la densité des électrons, de la charge et de la mobilité des porteurs qui se trouvent dans le canal.

Il ressort clairement de l'expression (57) que la sensibilité du détecteur Vinhall est très supérieure à celle du dispositif Hall. La valeur optimum du rapport longueur/largeur dans le cas d'un dispositif Hall est proche de l'unité et dans le cas d'un dispositif Vinhall, cette valeur est supérieure à cinq. Ainsi, en supposant que le rapport soit approximativement égal à 3 dans le cas d'un dispositif Hall moyen, le détecteur Vinhall le moins sensible sera au moins vingt fois plus sensible que le dispositif Hall équivalent le plus sensible.

On se reportera à présent aux figures 1 et 2, la figure 2 étant une coupe longitudinale du dispositif représenté sur la figure 1 et comportant un substrat en métal semi-conducteur 1 dans lequel une source 5 et un ou plusieurs drains 6 sont implantés ou diffusés. La surface du substrat, notamment à proximité du canal 4, est recouverte de façon classique d'une mince couche isolante d'oxyde 2, et d'une couche d'aluminium ou autre matériau conducteur déposé par évaporation ou autre technique appropriée et constituant une porte 7 à laquelle des tensions de commande appropriées peuvent être appliquées.

Cet ensemble constitue un transistor à effet de champ dans lequel, lorsque des tensions appropriées sont appliquées à la porte 7, à la source 5 et aux drains 6, un canal conducteur 4 de porteurs appelé "couche d'inversion" se forme entre la source et les drains. Cela a pour effet de créer une densité effective des porteurs qui peut être définie au moyen des mêmes termes que ceux précédemment utilisés dans le cas d'un dispositif à canal implanté dans lequel les porteurs ou les ions nécessaires pour former le canal sont implantés au-dessous de la surface du substrat. On peut démontrer que le signal de sortie d'un dispositif fonctionnant dans le mode d'enrichissement dans lequel les porteurs forment un canal conducteur, est une fonction linéaire de la tension appliquée à la porte et qu'un tel dispositif est moins sensible qu'un dispositif à canal enterré (fonctionnant dans le mode d'appauvrissement). La perte de sensibilité et d'amplitude du signal de sortie est le résultat de la faible épaisseur T du canal et d'une concentration élevée de donneurs $N_D$ dans celui-ci. Cette concentration a pour effet de diminuer l'importance de la modulation de la largeur des régions d'appauvrissement qui peut être obtenue pour un champ de Lorentz donné.

Les expressions ci-dessus montrent que les performances du détecteur, Vinhall sont exprimées entre autres paramètres, en termes de la quantité de porteurs qui est nécessaire pour former le canal. Cette quantité de porteurs n'est pas implantée dans les dispositifs Vinhall fonctionnant en mode d'enrichissement, mais ces derniers comportent un nombre équivalent de porteurs dans la couche d'inversion de charge créée par l'électrode de porte et par la couche mince d'oxyde qui sépare l'électrode de porte de la surface du substrat en silicium. En supposant que la concentration $N_D$ des porteurs qui sont inversés à la surface du canal soit uniforme dans une couche dont l'épaisseur T est d'environ 100 nm (1000 Å), une densité

21

**0 000 318**

induite équivalente $\overline{D}$ de porteurs peut être déterminée en considérant l'état des limites pour le champ diélectrique produit à la surface du semi-conducteur par la tension de porte qui traverse la couche mince d'oxyde en direction du substrat en silicium. La relation qui existe entre la densité $\overline{D}$ et la tension de porte $V_g$ est définie ci-après:

$$\overline{D} = \frac{V_g C_o}{2q} \tag{58}$$

où $C_o$ est la capacité de porte par cm$^2$ et est égale à la constante diélectrique e divisée par l'épaisseur de la couche d'oxyde $t_0$.

En substituant l'expression (58) ci-dessus dans les expressions précédentes relatives au fonctionnement en mode d'appauvrissement du dispositif Vinhall, on peut obtenir l'expression équivalente pour les dispositifs fonctionnant en mode d'enrichissement. On notera que les dispositifs Vinhall observent des principes identiques, qu'ils fonctionnent dans le mode d'enrichissement ou dans le mode d'appauvrissement.

La figure 4 représente une coupe longitudinale d'un substrat semi-conducteur typique 1 comportant un canal 4 enterré au-dessous de la surface du substrat et présentant les caractéristiques suivantes:

Le canal 4 est créé en implantant du phosphore, par exemple, de telle sorte qu'une concentration profonde et uniforme des porteurs soit obtenue au-dessous de la surface du substrat sur une profondeur d'environ 4000 A ou davantage. La densité des porteurs que l'on désire obtenir est d'environ $2 \times 10^{12}$ ions/cm$^2$ pendant l'implantation. Il est particulièrement souhaitable que cette implantation soit effectuée par étapes successives en employant des énergies variant entre 50 et 200 KeV.

Un canal profond présentant une épaisseur T de l'ordre de 400 nm (4000 Å) est donc obtenu à partir d'une région située à 50 nm (500 Å) environ au-dessous de la surface du substrat. Un tel canal permet d'obtenir le courant de canal nécessaire tout en rendant possible une modulation substantielle de la largeur des régions d'appauvrissement disposées le long de ses côtés. Ainsi, qu'on l'a précédemment observé, il est également important d'enterrer le canal à une profondeur suffisante pour réduire le bruit et augmenter le rapport signal/bruit. La porte de commande 7 fait fonction d'écran électrique servant à réduire le bruit, mais n'est pas nécessaire pour commander la conduction du canal.

La figure 5 représente une variante de la réalisation de la figure 4 dans laquelle la porte de commande en métal 7 a été complètement supprimée et qui comporte une couche isolante opaque 16 disposée au-dessus de la surface supérieure. L'objet de la couche opaque 16 est d'empêcher la lumière de pénétrer dans le substrat semi-conducteur et de provoquer du bruit par suite de la lumière émise par les électrons contenus dans le canal.

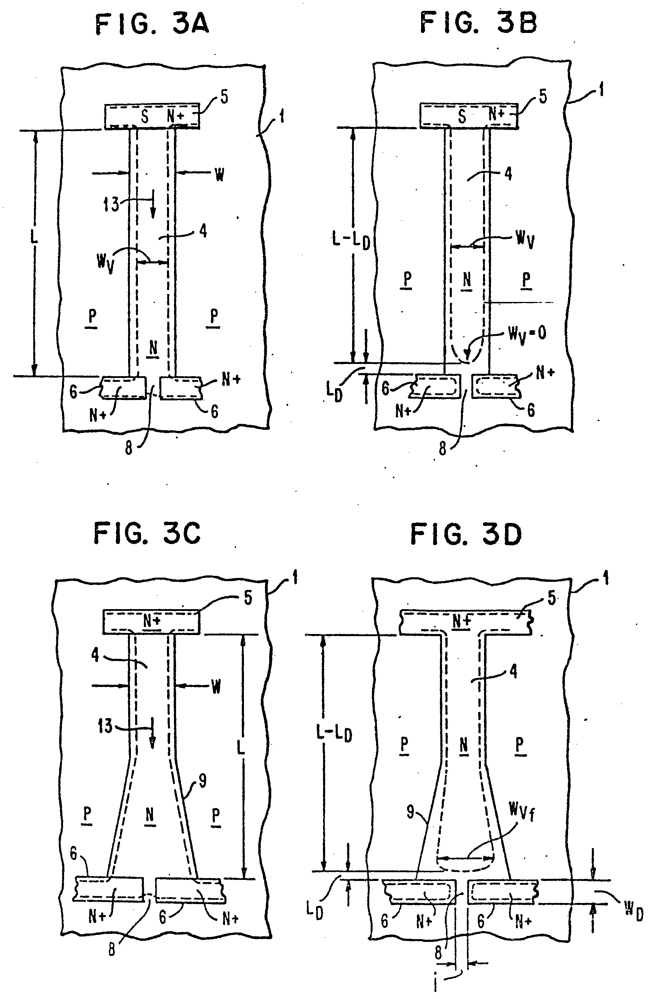

Les figures 3C, 3D et 7A à 7C représentent des détecteurs Vinhall à canal évasé. Cet évasement est dû à plusieurs raisons. Tout d'abord, ainsi qu'on l'a déjà mentionné, la largeur de la partie rectiligne du canal qui se trouve à proximité de la source commande le courant de canal 13 qui traverse le dispositif. Ce courant est virtuellement indépendant de ce qui se passe en aval, dans la partie évasée du canal qui se trouve plus près des drains. Cela permet de réduire au minimum le bruit dû à l'injection de la source et aux effets de la modulation de la longueur de la région d'appauvrissement à proximité des drains, et d'augmenter la stabilité du dispositif.

Deuxièmement, l'évasement du canal est nécessaire afin de tenir compte des modulations de plus en plus importantes de la largeur des régions d'appauvrissement qui se produisent le long des côtés du canal plus près des drains. Ces modulations de plus en plus importantes de la largeur résultent du fait que la tension de drain augmente en fonction de l'éloignement de la source (et du rapprochement des drains). En l'absence de cet évasement, il se produirait un pincement du canal étroit (voir figure 3B) à proximité des drains, la largeur Vinhall $W_v$ devenant de ce fait nulle. En pareil cas, aucun champ de Lorentz ne pourrait provoquer de déplacement de la limite des régions d'appauvrissement puisque la tension de Lorentz $VBW_v$ serait nulle. L'évasement du canal permet d'éviter que la modulation de sa largeur ne provoque un pincement effectif de la totalité de la largeur Vinhall. Cette situation est représentée sur la figure 3D au point où le pincement longitudinal se produit dans le canal à proximité des drains. Ce point est situé à une distance $L—L_D$ de la source.

La largeur Vinhall évasée $W_{vf}$ désirée à proximité des drains est fonction de la largeur de la fente 8 qui, sur la figure 3D, sépare les drains. La largeur Vinhall évasée qui est désignée $W_{vf}$ doit être au moins égale à la largeur de la fente 8.

La partie la plus sensible du dispositif Vinhall se trouve à proximité des drains et est la seule région qui nécessite un champ magnétique pour moduler les limites des régions d'appauvrissement. Cette caractéristique du détecteur Vinhall explique non seulement sa résolution élevée, mais aussi sa grande sensibilité. Le détecteur Vinhall fait donc essentiellement fonction de détecteur ponctuel. Il est préférable, mais non indispensable, que le dispositif Vinhall soit utilisé dans le mode de pincement. Une telle situation est représentée sur les figures 7A à 7C et sur la figure 3D.

Si le dispositif Vinhall fonctionne au-dessous de la tension de pincement (voir figure 9), il est souhaitable que la largeur $W_d$ des drains 6 soit égale ou inférieure à la largeur de la fente 8. Si tel n'était

22

pas le cas, la conductance entre les drains 6 atténuerait de façon excessive les signaux différentiels obtenus entre les drains.

Il est souhaitable que les drains 6 soient séparés par une faible distance de manière à obtenir une sensibilité optimum du dispositif Vinhall. Des techniques spéciales de fabrication peuvent être employées à cette fin. L'une de ces techniques consiste à implanter les deux drains 6 aussi près l'un de l'autre que les techniques de masquage photolithographique le permettent, puis à procéder à une opération de recuit qui limite la migration des ions qui se produit à une température de recuit proche de la température de diffusion. Cette température est d'environ 1000°C dans le cas du silicium, mais varie avec différents matériaux. Le résultat de cette opération est l'obtention d'une séparation dont la largeur est inférieure à la largeur minimum du masque qui est rendue possible par la technique photolithographique employée. Un second procédé permettant d'obtenir une séparation plus étroite consiste à implanter initialement une région de drain ininterrompue et de former ensuite une séparation au moyen d'une technique faisant appel à l'emploi d'un faisceau électronique. Des ions de matériau de type de conductivité opposé à celui du matériau qui se trouve déjà dans la région de la séparation peuvent ensuite être implantés de manière à créer une séparation électrique entre les drains. Le matériau implanté forme une séparation effective qui neutralise l'implantation initialement effectuée dans cette région. De la sorte, on peut obtenir une région de séparation présentant une résistivité intrinsèque ou une conductivité du même type que le matériau constituant le canal. Les drains séparés ainsi formés sont fortement dopés de manière à prévenir leur appauvrissement à des tensions de drain élevées.

Ayant ainsi décrit l'invention dans le contexte de plusieurs réalisations de celle-ci, il est intéressant de comparer la forme "filament" typique d'un dispositif Vinhall avec celle de plusieurs dispositifs connus. La forme du dispositif Vinhall est définie par le rapport de la largeur Vinhall $W_v$ à la largeur totale W du canal. L'expression (25) constituera le point de départ de cette étude. Dans cette dernière expression la largeur de la région d'appauvrissement qui se trouve le long d'un des côtés du canal, à l'intérieur de celui-ci, est déterminée en fonction de plusieurs variables. On supposera que ces dernières ont les valeurs optimum ci-après:

$$e_s \quad = 1{,}04 \times 10^{-12} \text{ farads/cm}$$

$$q \quad = 1{,}6 \times 10^{-19} \text{ coulombs}$$

$$N_A \quad = N_D = 10^{17} \text{ ions/cm}^3, \text{ et}$$

$$\psi_o \quad (\text{selon l'expression (24)}) = 4 \times 10^{-1}$$

En pareil cas, la largeur de la couche d'appauvrissement à proximité de la source d'un dispositif Vinhall (largeur pour laquelle le terme V dans l'expression (25) est nul) est d'environ 51 nm (510 Å). La largeur totale de la région appauvrie est égale au double de cette valeur, soit environ 100 nm (1000Å), et, dans le cas le plus défavorable, c'est-à-dire un dispositif Vinhall à canal large, avec une largeur de canal de 5 $\mu$m (50000 Å), le rapport $W_v$ divisé par W est égal à 0,98. Si l'on choisit une largeur totale du canal plus appropriée de 2.5 $\mu$m (25 000 A), ce rapport devient 0,96.

Ce qui précède suppose le cas le plus défavorable pour un dispositif Vinhall en ce qui concerne la largeur et le cas le plus favorable en ce qui concerne la largeur des régions d'appauvrissement. Une comparaison est effectuée ci-après avec quelques dispositifs classiques pris dans les conditions les plus favorables.

Dans le cas d'un dispositif à effet Hall typique présentant les plus petites dimensions prévues, soit $6.10^{-4}$ mm² environ, le rapport de la largeur Vinhall à largeur du canal est d'environ 0,999 à proximité de la source. Elargir ou allonger le dispositif Hall n'aurait d'autres résultats que de rendre la valeur de ce rapport plus proche de l'unité étant donné que la largeur des régions d'appauvrissement définie par l'expression (25) n'est pas fonction de la largeur du canal.

Dans le cas du dispositif décrit dans la publication intitulée "IBM Technical Disclosure Bulletin", Vol. 13, No.12, mai 1971, page 3633, et en supposant que les dimensions physiques de celui-ci soient les plus favorables, le rapport ci-dessus est proche de 0,998 à proximité de la source. Cela suppose que les drains du dispositif seraient les plus petits possibles, c'est-à-dire qu'ils auraient une largeur d'environ 0,051mm, et que la largeur de la source, telle que celle-ci est représentée dans ladite publication, aurait une largeur d'environ 0,203mm par rapport aux drains.

Dans le cas du dispositif décrit dans la publication précitée, Vol.14, No.11, avril 1972, page 3420, la valeur dudit rapport est d'environ 0,998 à proximité de la source, en supposant que les drains représentés dans ladite publication aient une largeur d'environ 0,152mm et qu'ils soient séparés par une distance de 0,051mm, cette dernière valeur représentant approximativement la limite extrême de la résolution pour le type de technique décrite.

L'analyse ci-dessus montre que, dans le cas des dispositifs classiques, la valeur dudit rapport dépasse 0,98 dans le cas le plus favorable alors que cette valeur constitue un maximum pour le dispositif Vinhall dans le cas le plus défavorable à proximité de la source. L'objet de cette analyse est de montrer que, dans le cas dispositif Vinhall selon l'invention, la valeur dudit rapport est inférieure à 0,98

# 0 000 318

et supérieure à zéro, ce qui revient à dire que les régions d'appauvrissement constituent une partie substantielle du canal conducteur. Ce résultat diffère radicalement de l'art antérieur et ne peut être obtenu que si l'on tient compte des caractéristiques du processus de modulation de la largeur des régions d'appauvrissement et que si l'on tient compte du fait que la largeur du canal doit être aussi faible que possible.

Bien que l'on ait décrit dans ce qui précède et représenté sur les dessins les caractéristiques essentielles de l'invention appliquées à des modes de réalisation préférés de celle-ci, il est évident que l'homme de l'art peut y apporter toutes modifications de forme ou de détail qu'il juge utiles, sans pour autant sortir du cadre de ladite invention.

**Revendications**

1. Détecteur de champ magnétique ou électrique, du type comportant un substrat (1) en matériau semi-conducteur dans lequel sont formés une région de source (5) et au moins deux régions de drains (6) distinctes, séparées d'une distance prédéterminée (8), ainsi qu'un canal (4) de conduction reliant ladite région de source auxdites régions de drains, ledit détecteur étant caractérisé en ce que son canal (4) de conduction est en forme de filament, le rapport entre la largeur totale (W) du canal (4) diminuée de la somme des largeurs des régions d'appauvrissement ($I_n$) se trouvant le long des côtés du canal (4), d'une part, (cette différence est appelée ci-après "largeur Vinhall" ($W_v$)) et la largeur totale (W) du canal d'autre part, ayant une valeur supérieure à 0 et inférieure à 0,98 au voisinage de ladite région de source.

2. Détecteur selon la revendication 1 caractérisé en ce que la valeur obtenue en divisant la distance entre la région de source (6) et les régions de drains ($D_1$, $D_2$) par ladite largeur Vinhall ($W_v$), est supérieure à la valeur du demi produit de la résistance de charge multipliée par la densité des porteurs dans le canal, par la mobilité des porteurs du canal et par la charge unitaire des électrons.

3. Détecteur selon la revendication 1, caractérisé en ce que le rapport entre la largeur Vinhall ($W_v$) du canal (4) au voisinage des régions de drain ($D_1$, $D_2$) d'une part et la largeur Vinhall ($W_v$) au voisinage de ladite source (6) d'autre part, est supérieur à 1.

4. Détecteur selon la revendication 1, caractérisé en ce que:

le rapport entre la largeur Vinhall ($W_v$) au voisinage des régions de drains ($D_1$, $D_2$), d'une part, et la largeur Vinhall ($W_v$) en un point intermédiaire entre les régions de drains ($D_1$, $D_2$) et la région de source (6), d'autre part, est supérieur à 1; et en ce que:

le rapport entre la largeur Vinhall ($W_v$) audit point intermédiaire et la largeur Vinhall au voisinage de la région de source (6) est égal à 1.

5. Détecteur selon l'une quelconque des revendications 1 à 4 caractérisé en ce que ladite distance prédéterminée (8) séparant les régions de drains ($D_1$, $D_2$) a une valeur inférieure à la largeur Vinhall ($W_v$).

6. Détecteur selon l'une quelconque des revendications 1 à 5 caractérisé en ce que la largeur des régions de drains ($W_d$), telle que mesurée parallèlement à l'axe du canal (4), est inférieure à ladite distance prédéterminée (8) séparant les régions de drains ($D_1$, $D_2$).

7. Détecteur selon l'une quelconque des revendications 1 à 6 caractérisé en ce que ledit canal (4) s'étend au-dessous de la surface dudit substrat (1) et est séparé de cette dernière par une couche de matériau dont la conductivité est de type opposé à celle dudit canal et dont l'épaisseur est inférieure à ladite largeur Vinhall (Fig. 4, 5).

8. Détecteur selon l'une quelconque des revendications 1 à 7 caractérisé en ce que la largeur Vinhall ($W_v$) du canal est supérieure à l'épaisseur (T) du canal (4) telle que mesurée perpendiculairement à la surface du substrat (1).

9. Détecteur selon la revendication 1 caractérisé en ce que la largeur Vinhall ($W_v$) au voisinage des régions de drains ($D_1$, $D_2$) est supérieure à 0 et inférieure à la quantité définie par l'expression

$$\frac{KT_o}{qBV},$$

dans laquelle

K    est la constante de Bolzmann,

$T_o$    la température de Kelvin,

q    la charge unitaire des électrons,

$V$    la vitesse de saturation des porteurs et

B    l'induction du champ magnétique détecté.

24

# 0 000 318

## Patentansprüche

1. Abfühlvorrichtung für magnetische oder elektrische Felder aus einem aus Halbleitermaterial bestehenden Substrat (1), in welchem eine Quellenzone (5) und mindestens zwei verschiedene, durch einen vorbestimmten Abstand (8) getrennte Senkenzonen (6), sowie ein die Quellenzone und die Senkenzonen verbindender Leitungskanal (4) ausgebildet sind, dadurch gekennzeichnet, daß der Leitungskanal (4) fadenförmig ausgebildet ist, und daß das Verhältnis zwischen der durch die Summe der Breiten der Verarmungszonen ($I_n$) entlang den Kanalseiten verminderten Gesamtbreite (W) des kanals (4) — (diese Differenz wird im folgenden als Vinhall-Breite ($W_v$)' bezeichnet) — und der Gesamtbreite (W) des Kanals einen Wert zwischen 0 und 0,98 in der Nähe der Quellenzone ergibt.

2. Abfühlvorrichtung nach Anspruch 1, dadurch gekennzeichnet, daß sich durch Division des Abstands zwischen der Quellenzone (S) und den Senkenzonen ($D_1$, $D_2$) mit der Vinhall-Breite ($W_v$) ein Wert ergibt, der größer ist als die Hälfte des Produktes aus der Ladungsträgerdichte im Kanal, der Beweglichkeit dieser Ladungsträger, der Einheitsladung der Elektronen und des Lästwiderstandes.

3. Abfühlvorrichtung nach Anspruch 1, dadurch gekennzeichnet, daß das Verhältnis zwischen der Vinhall-Breite ($W_v$) des kanals (4) in der Nähe der Senkenzonen ($D_1$, $D_2$) und der Vinhall-Breite ($W_v$) in der Nähe der Quelle (S) größer als 1 ist.

4. Abfühlvorrichtung nach Anspruch 1, dadurch gekennzeichnet, daß das Verhältnis zwischen der Vinhall-Breite ($W_v$) in der Nähe der Senkenzonen ($D_1$, $D_2$) und der Vinhall-Breite ($W_v$) an einem Zwischenpunkt zwischen den Senkenzonen ($D_1$, $D_2$) und der Quellenzone (S) größer als 1 ist, und daß das Verhältnis zwischen der Vinhall-Breite ($W_v$) an diesem Zwischenpunkt und der Vinhall-Breite in der Nähe der Quellenzone (S) gleich 1 ist.

5. Abfühlvorrichtung nach einem der Ansprüche 1 bis 4, dadurch gekennzeichnet, daß der Wert des die Senkenzonen ($D_1$, $D_2$) trennenden, vorbestimmten Abstands (8) kleiner als die Vinhall-Breite ($W_v$) ist.

6. Abfühlvorrichtung nach einem der Ansprüche 1 bis 5, dadurch gekennzeichnet, daß die parallel zur Achse des Kanals (4) gemessene Senkenzonen-Breite ($W_d$) kleiner ist als die die Senkenzonen ($D_1$, $D_2$) trennende, vorbestimmte Entfernung (8).

7. Abfühlvorrichtung nach einem der Ansprüche 1 bis 6, dadurch gekennzeichnet, daß sich der Kanal (4) unter der Oberfläche des Substrats (1) erstreckt und von dieser durch eine Materialschicht getrennt ist, deren Leitfähigkeit der des Kanals entgegengesetzt ist und deren Dicke kleiner als die Vinhall-Breite ist (Fign. 4, 5).

8. Abfühlvorrichtung nach einem der Ansprüche 1 bis 7, dadurch gekennzeichnet, daß die Vinhall-Breite ($W_v$) des Kanals größer als die senkrecht zur Oberfläche des Substrats (1) gemessene Dicke (T) des Kanals (4) ist.

9. Abfühlvorrichtung nach Anspruch 1, dadurch gekennzeichnet, daß die Vinhall-Breite (WV) in der Nähe der Senkenzonen ($D_1$, $D_2$) größer als 0 und kleiner als die in nachstehendem Ausdruck definierte Größe ist:

$$\frac{KT_o}{qBV},$$

wobei:

K die Boltzmannkonstante,

$T_o$ die Temperatur in Kelvin,

q die Einheitsladung der Elektronen,

V die Sättigungsgeschwindigkeit der Träger,

B die Induktion des abgefühlten Magnetfeldes

darstellt.

## Claims

1. Magnetic or electric field sensor of the type comprising a substrate (1) made of a semiconductor material in which are formed a source region (5) and at least two distinct drain regions (6), separated by a predetermined distance (8), as well as a conductive channel (4) connecting said source region to said drain regions, said sensor being characterized in that its conductive channel (4) is filament-shaped, the ratio of the total width (W) of the channel (4), diminished by the sum of the widths of the depletion layers ($I_n$) adjacent to the edges of the channel (4) (this difference being referred to

25

hereinafter as Vinhall width ($W_v$)), to the total channel width (W) having a value, in the vicinity of said source region, greater than 0 and less than 0.98.

2. Sensor according to claim 1, characterized in that the value obtained by dividing the distance between the source region (5) and the drain regions ($D_1$, $D_2$) by said Vinhall width ($W_v$) is greater than the value of the half product of the load resistance multiplied by the channel carrier density, by the channel carrier mobility, and by the electron unit charge.

3. Sensor according to claim 1, characterized in that the ratio of the Vinhall width ($W_v$) of the channel (4) in the vicinity of the drain regions ($D_1$, $D_2$) to the Vinhall width ($W_v$) in the vicinity of said source (5) is greater than 1.

4. Sensor according to claim 1, characterized in that:

the ratio of the Vinhall width ($W_v$) in the vicinity of the drain regions ($D_1$, $D_2$) to the Vinhall width ($W_v$) at an intermediate point between the drain regions ($D_1$, $D_2$) and the source region (5) is greater than 1, and in that:

the ratio of the Vinhall width ($W_v$) at said intermediate point to the Vinhall width in the vicinity of the source region (5), is equal to 1.

5. Sensor according to any one of claims 1 to 4, characterized in that said predetermined distance (8) separating the drain regions ($D_1$, $D_2$) is less than the Vinhall width ($W_v$).

6. Sensor according to any one of claims 1 to 5, characterized in that the width of the drain regions ($W_d$), taken parallel to the axis of the channel (4), is less than the predetermined distance (8) separating the drain regions ($D_1$, $D_2$) from one another.

7. Sensor according to any one of claims 1 to 6, characterized in that said channel (4) lies beneath the surface of said substrate (1) and is separated therefrom by a layer of material whose conductivity is of a type opposite to that of said channel, and whose width is less than said Vinhall width (Figs. 4, 5).

8. Sensor according to any one of claims 1 to 7, characterized in that the Vinhall width ($W_v$) of the channel is larger than the thickness (T) of the channel (4), in the direction perpendicular to the surface of the substrate (1).

9. Sensor according to claim 1, characterized in that the Vinhall width ($W_v$) in the vicinity of the drain regions ($D_1$, $D_2$) is greater than 0 and less than the quantity defined by the expression:

$$\frac{KT_o}{qBV},$$

where:

K    is the Boltzmann constant,

$T_o$    is the Kelvin temperature,

q    is the unit charge of the electrons,

V    is the saturation speed of the carriers, and

B    is the induction of the sensed magnetic field.

FIG. 1

FIG. 2

# FIG. 3A

# FIG. 3B

# FIG. 3C

# FIG. 3D

## FIG. 4

## FIG. 5

## FIG. 6

0 000 318

## FIG. 8

## FIG. 9

## FIG. 11A

## FIG. 11B

## FIG. 11C

4

0 000 318

FIG. 10A

FIG. 10B
CHAMP ELECTRIQUE

FIG. 10C

POTENTIEL

5

# FIG. 12

# FIG. 13A

# FIG. 13B

# FIG. 14A

# FIG. 14B

# FIG. 7A

# FIG. 7B

# FIG. 7C

FIG. 15A

FIG. 15B

FIG. 15C

FIG. 15D

FIG. 15E